(19) Europäisches Patentamt
European Patent Office
Office européen des brevets

(11) **EP 3 892 437 B1**

(12) **EUROPEAN PATENT SPECIFICATION**

(45) Date of publication and mention
of the grant of the patent:
**23.08.2023  Bulletin 2023/34**

(21) Application number: **19891902.9**

(22) Date of filing: **26.11.2019**

(51) International Patent Classification (IPC):
*B29C 39/10* (2006.01)      *B29C 39/18* (2006.01)
*B29C 39/24* (2006.01)      *B32B 27/00* (2006.01)
*C08J 7/04* (2020.01)       *C09D 201/06* (2006.01)
*C09D 201/08* (2006.01)     *B32B 37/26* (2006.01)
*H01L 21/301* (2006.01)     *B29K 63/00* (2006.01)
*C08J 7/046* (2020.01)

(52) Cooperative Patent Classification (CPC):
**C08J 7/046; C08J 7/0427;** B29C 39/10;
B29C 39/24; B29K 2063/00; C08J 2323/02;
C08J 2433/06

(86) International application number:
**PCT/JP2019/046118**

(87) International publication number:
**WO 2020/116234 (11.06.2020 Gazette 2020/24)**

(54) **HARD COATING LAYER-LAMINATED MOLD RESIN AND METHOD FOR PRODUCING SAME**

HARTBESCHICHTETES GIESSHARZ UND VERFAHREN ZU SEINER HERSTELLUNG

RÉSINE MOULÉE RECOUVERTE D'UNE COUCHE DE REVÊTEMENT DUR ET PROCÉDÉ POUR SA PRODUCTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.12.2018   JP 2018227128**

(43) Date of publication of application:
**13.10.2021   Bulletin 2021/41**

(73) Proprietors:
• **Harima Chemicals, Incorporated
  Kakogawa-shi, Hyogo 675-0019 (JP)**
• **Hamamatsu Photonics K.K.
  Hamamatsu-shi, Shizuoka 435-8558 (JP)**

(72) Inventors:
• **NAKAI, Ryouichi
  Hyogo 675-0019 (JP)**
• **KITAJIMA, Yutaka
  Hyogo 675-0019 (JP)**
• **SUGIURA, Hisaya
  Shizuoka 435-8558 (JP)**

• **IKEYA, Takayuki
  Shizuoka 435-8558 (JP)**

(74) Representative: **SSM Sandmair
Patentanwälte Rechtsanwalt
Partnerschaft mbB
Joseph-Wild-Straße 20
81829 München (DE)**

(56) References cited:
**EP-A1- 2 161 126        WO-A1-01/25362
JP-A- H11 170 295        JP-A- 2000 177 070
JP-A- 2006 328 364       JP-A- 2012 056 237
JP-A- 2013 072 076**

• **DATABASE WPI Week 201274 Thomson
  Scientific, London, GB; AN 2012-N98852
  XP002807236, & JP 2012 210756 A (NIPPON
  SEISHI CHEM KK) 1 November 2012 (2012-11-01)**
• **DATABASE WPI Week 201401 Thomson
  Scientific, London, GB; AN 2013-W81627
  XP002807237, & WO 2013/183558 A1 (NIPPON
  SODA CO) 12 December 2013 (2013-12-12)**

**Description**

TECHNICAL FIELD

The present invention relates to a hard coating layer-laminated mold resin and a producing method thereof. In particular, the present invention relates to a hard coating layer-laminated mold resin and a producing method thereof.

BACKGROUND ART

Conventionally, it has been required to give various functionalities such as mechanical properties, abrasion resistance, and blocking resistance to a molded resin article (mold resin). To fulfill the requirement, it has been known to cover the surface of the mold resin with a functional layer as taught for instance in EP 2 161 126.
More specifically, for example, a transfer material in which a hard coating layer, a design layer, and an adhesive layer are sequentially laminated on a substrate sheet having releasability has been proposed. It has also been proposed that, by disposing the transfer material in a mold and injecting and filling melt resin in the mold, the hard coating layer is laminated on the resin article through the adhesive layer and the substrate sheet is peeled and, thereafter, the hard coating layer is crosslinked and cured by, for example, an active energy ray (for example, see Patent Document 1 below).
In this manner, the resin article is adhered to the hard coating layer through the adhesive layer, thereby producing a hard coating layer-laminated resin article.

Citation List

Patent Document

Patent Document 1: Japanese Unexamined Patent Publication No. 2014-193524

SUMMARY OF THE INVENTION

PROBLEM TO BE SOLVED BY THE INVENTION

On the other hand, in the transfer material of Patent Document 1, a hard coating layer, a design layer, and an adhesive layer are sequentially laminated on a substrate sheet and thus the adhesive layer is exposed as the top layer. As a result, when the transfer material is disposed in a mold and melt resin is injected and filled in the mold, the adhesive layer sometimes adheres to and contaminates the mold.
To suppress the contamination of the mold, it is considered to omit the adhesive layer. However, in such a case, there is a disadvantage that the hard coating layer cannot adhere to the resin article.
Alternatively, it is considered that, instead of the disposition of the transfer material in the mold, for example, a resin cured in the mold and a transfer material are separately prepared and aligned with a jig to transfer the hard coating layer through the adhesive layer.
In such a method, however, the adhesive layer is in contact with the jig. Thus, the adhesive layer sometimes adheres to and contaminates the jig.
The present invention provides a method of producing a hard coating layer-laminated mold resin that can suppress the contamination of molding tools such as a mold and a jig and a hard coating layer-laminated mold resin produced by the method.

MEANS FOR SOLVING THE PROBLEM

The present invention [1] includes a method of producing a hard coating layer-laminated mold resin comprising: a transfer material preparation step of preparing a transfer material including a multi-layered sheet including a substrate sheet and a protective layer that is disposed on one surface of the substrate sheet and for protecting at least a part of a surface of a mold resin, the protective layer being an uppermost layer of the multi-layered sheet, the protective layer including a product of an active energy ray-curable resin cured or half-cured by active energy ray, and the protective layer having a thermally reactive group and a polysiloxane chain, and the thermally reactive group being capable of reacting and thermally curing with the mold resin in a thermally uncured and/or half-cured state; a resin preparation step of preparing the thermally uncured and/or half-cured mold resin; a disposition step of disposing the transfer material so that the protective layer is exposed; and a transfer step of bringing into contact and heating the thermally uncured and/or half-cured mold resin and the protective layer to transfer a hard coating layer to the mold resin, the hard coating layer being produced by thermally curing the protective layer, wherein, in the transfer step, the protective layer and the mold resin are reacted and chemically bonded to each other, the thermally uncured and/or half-cured mold resin is cured, and the protective layer is further cured to form the hard coating layer.

The present invention [2] includes the method described in [1] above, wherein, in the transfer step, the mold resin in a thermally uncured state and the protective layer in a thermally uncured state are heated in their contact situation to chemically bond the mold resin to the protective layer.

The present invention [3] includes the method described in [1] or [2] above, wherein the transfer step comprising: a first heating step of heating the mold resin in a thermally uncured state and the protective layer in a thermally uncured state in their contact situation to chemically bond the mold resin in a half-thermally cured state to the protective layer in a half-thermally cured state; and a second heating step of heating the half-cured mold resin and the half-cured protective layer after the first heating step.

The present invention [4] includes the method described in [1] above, wherein the transfer step comprises a transfer step of heating the mold resin molded in advance and in a half-thermally cured state and the protective layer in a thermally uncured state in their contact situation to chemically bond the mold resin to the protective layer.

The present invention [5] includes the method described in [1] or [2] above, wherein in the transfer step comprises a first heating step of heating the mold resin molded in advance and in a half-thermally cured state and the protective layer in a thermally uncured state in their contact situation to chemically bond the mold resin in a half-cured state and the protective layer in a half-cured state; and a second heating step of heating the half-cured mold resin and the half-cured protective layer after the first heating step.

The present invention [6] includes the method described in any one of the above-described [1] to [5] wherein in the transfer step, a hard coating layer-laminated mold resin assembly including a plurality of the hard coating layer-laminated mold resins are molded, and the method further comprises a dicing step of dividing the hard coating layer-laminated mold resin assembly into the plurality of hard coating layer-laminated mold resins after the transfer step.

The present invention [7] includes the method described in [6] above, wherein, in the dicing step, the plurality of hard coating layer-laminated mold resins are produced by blade dicing.

The present invention [8] includes the method described in [6] above, wherein, in the dicing step, the hard coating layer-laminated mold resins are produced by laser dicing.

The present invention [9] includes the method described in any one of the above-described [6] to [8], wherein a dicing tape is disposed before the division in the dicing step and after the transfer step.

The present invention [10] includes the method described in any one of the above-described [6] to [8], wherein a dicing tape is disposed before the division in the dicing step and before the transfer step.

The present invention [11] includes the method described in any one of the above-described [1] to [10], wherein a semiconductor device is sealed in the mold resin.

The present invention [12] includes the method described in [11] above, wherein the semiconductor device is a photo semiconductor device.

The present invention [13] includes the method described in [11] or [12] above, wherein the mold resin is epoxy resin and/or silicone resin.

The present invention [14] includes the method described in [13] above, wherein the thermally reactive group of the protective layer is at least one selected from a group consisting of a hydroxyl group, an epoxy group, a carboxy group, and a (meth)acryloyl group.

The present invention [15] includes a hard coating layer-laminated mold resin comprising: a mold resin; and a hard coating layer that protects at least a part of a surface of the mold resin, wherein the hard coating layer is a cured product of an active energy ray-curable resin having a thermally reactive group and a polysiloxane chain, the thermally reactive group can react and thermally cure with the mold resin in a thermally uncured and/or half-cured state, and the hard coating layer and the mold resin are connected through a chemical bond of the thermally reactive group of the active energy ray-curable resin and the mold resin.

The present invention [16] includes the hard coating layer-laminated mold resin described in [15] above, further comprising a semiconductor device sealed in the mold resin.

The present invention [17] includes the hard coating layer-laminated mold resin described in [16] above, wherein the semiconductor device is a photosemiconductor device.

The present invention [18] includes the hard coating layer-laminated mold resin described in [17] above, wherein the photosemiconductor device is a light receiving element.

The present invention [19] includes the hard coating layer-laminated mold resin described in [17] above, wherein the photosemiconductor device is a light emitting element.

The present invention [20] includes the hard coating layer-laminated mold resin described in any one of the above-described [17] to [19] further comprising: a substrate electrically connected to the photo semiconductor device, wherein the substate, the mold resin and the hard coating layer are sequentially laminated from one side toward the other side, the mold resin includes a surface of the one side, a surface of the other side, and a peripheral surface connecting the surface of the one side and the surface of the other side, and the hard coating layer is disposed only on the surface of the other side of the mold resin and is not disposed on the peripheral surface of the mold resin.

The present invention [21] includes the hard coating layer-laminated mold resin described in any one of the above-described [17] to [20], wherein a surface roughness of the peripheral surface of the mold resin is larger than a surface roughness of the hard coating layer.

The present invention [22] includes the hard coating layer-laminated mold resin described in any one of the above-described [17] to [21], wherein a surface roughness of the peripheral surface of the hard coating layer is larger than the roughness of the surface of the hard coating layer.

EFFECTS OF THE INVENTION

In the multi-layered sheet and transfer material used in the method of the hard coating layer-laminated mold resin of the present invention, a protective layer includes a product of an active energy ray-curable resin cured or half-cured by active energy ray and has a thermally reactive group capable of reacting and thermally curing with a thermally uncured and/or half-thermally cured mold resin, and a polysiloxane chain.

Thus, the thermally uncured and/or half-thermally cured mold resin and the protective layer are brought into contact and heated, thereby chemically bonding to each other. Further, the thermally uncured and/or half-thermally cured mold resin is cured, thereby molding the mold resin as a cured product. In addition, the protective layer is cured, thereby producing a hard coating layer.

This allows the hard coating layer to adhere to the mold resin without providing an adhesive layer.

Further, in the multi-layered sheet and transfer material used in the method of producing the hard coating layer-laminated mold resin of the present invention, the protective layer has a polysiloxane chain. Thus, even when the surface of the protective layer is in contact with a molding tool such as a mold or a jig, the adherence of the protective layer to the molding tool is suppressed. Therefore, the contamination of the molding tool is suppressed.

That is, the method of producing the hard coating layer-laminated mold resin of the present invention can suppress the contamination of the molding tool and can efficiently produce a hard coating layer-laminated mold resin with excellent adhesion between the mold resin and the hard coating layer.

Furthermore, the hard coating layer-laminated mold resin is produced while the contamination of the molding tool is suppressed. The mold resin adheres to the hard coating layer without the mediation of an adhesive layer.

BRIEF DESCRIPTION OF THE DRAWINGS

[FIG. 1] FIG. 1 is a schematic view showing an embodiment of the multi-layered sheet used in the method of producing the hard coating layer-laminated mold resin of the present invention.

[FIG. 2] FIG. 2 is a schematic view showing an embodiment of the hard coating layer-laminated mold resin of the present invention.

[FIG. 3] FIG. 3 is a flow diagram showing an embodiment of the method of producing the hard coating layer-laminated mold resin of the present invention. FIG. 3A illustrates a transfer material preparation step. FIG. 3B illustrates a disposition step. FIG. 3C illustrates a transfer step. FIG. 3D illustrates a release step.

[FIG. 4] FIG. 4 is a schematic view showing another embodiment of the multi-layered sheet used in the method of producing the hard coating layer-laminated mold resin of the present invention.

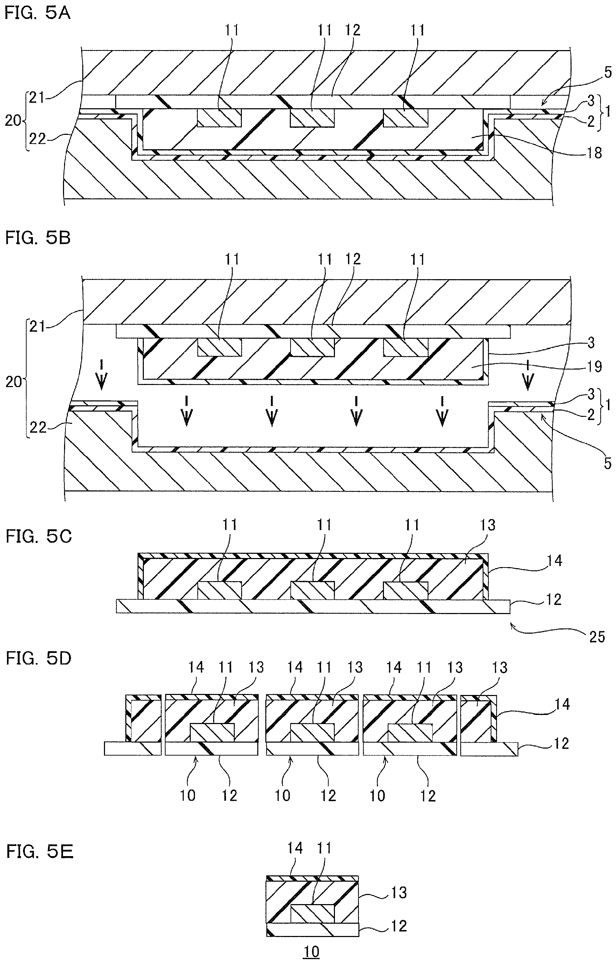

[FIG. 5] FIG. 5 is a flow diagram showing another embodiment of the method of producing the hard coating layer-laminated mold resin of the present invention. FIG. 5A illustrates a first heating step for bringing into contact and pre-curing the thermally uncured mold resin and the thermally uncured protective layer to chemically bond the half-thermally cured mold resin to the half-thermally cured protective layer in the transfer step. FIG. 5B illustrates a release step for releasing the transfer material from the half-thermally cured mold resin. FIG. 5C illustrates a second heating step for post-curing the half-thermally cured mold resin and the half-thermally cured protective layer in the transfer step. FIG. 5D illustrates a dicing step for dividing an assembly of the hard coating layer-laminated mold resins into a plurality of the hard coating layer-laminated mold resins after the transfer step. FIG. 5E illustrates a step for producing the hard coating layer-laminated mold resin.

[FIG. 6] FIG. 6 is a flow diagram showing another embodiment of the method of producing the hard coating layer-laminated mold resin of the present invention. FIG. 6A illustrates a step for provisionally molding a mold material in the mold. FIG. 6B illustrates a resin preparation step for preparing a half-cured mold product molded in advance. FIG. 6C illustrates a disposition step for disposing the transfer material relative to the half-cured mold product.

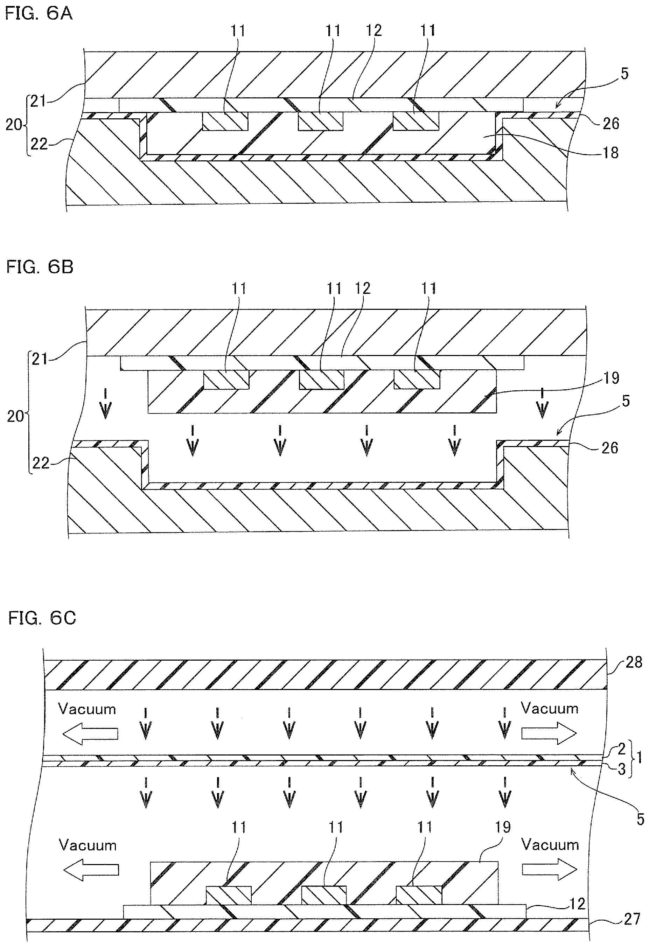

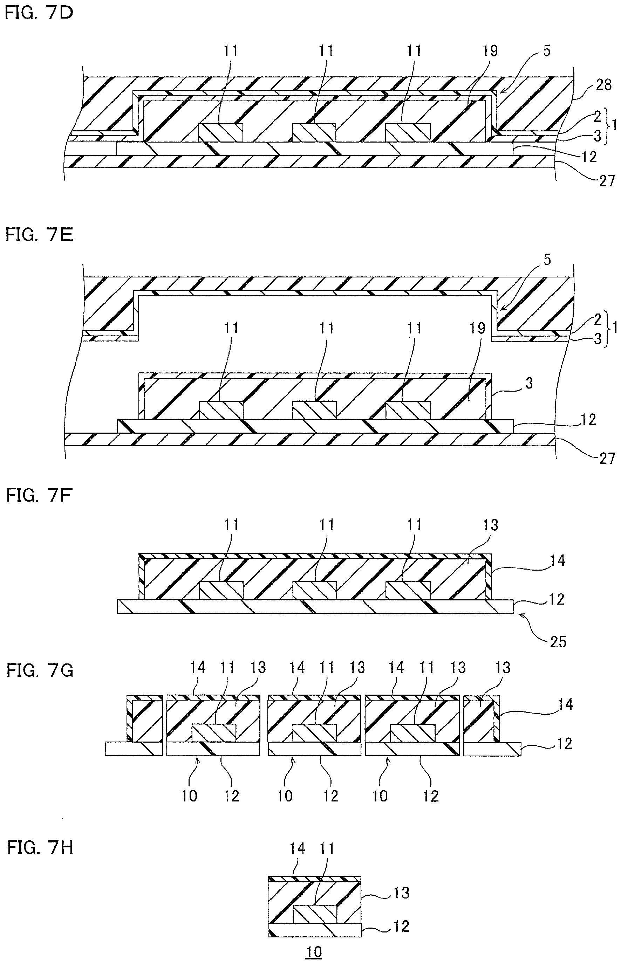

[FIG. 7] Following FIG. 6, FIG. 7 is a flow diagram showing another embodiment of the method of producing the hard coating layer-laminated mold resin of the present invention. FIG. 7D illustrates a first heating step for bringing into contact and heating the half-thermally mold resin and the thermally uncured protective layer to chemically bond the half-thermally cured mold resin to the half-thermally cured protective layer in the transfer step. FIG. 7E illustrates a release step for releasing the transfer material from the half-thermally cured mold resin. FIG. 7F illustrates a second heating step for post-curing the half-thermally cured mold resin and the half-thermally cured protective layer in the transfer step. FIG. 7G illustrates a dicing step for dividing an assembly of the hard coating layer-laminated mold resins into a plurality of the hard coating layer-laminated mold resins after the transfer step. FIG. 7H illustrates a step for producing the hard coating layer-laminated mold resin.

[FIG. 8] FIG. 8 is a schematic plan view showing another embodiment of a multi-layered sheet used in the method of producing the hard coating layer-laminated mold resin of the present invention.

DESCRIPTION OF THE EMBODIMENTS

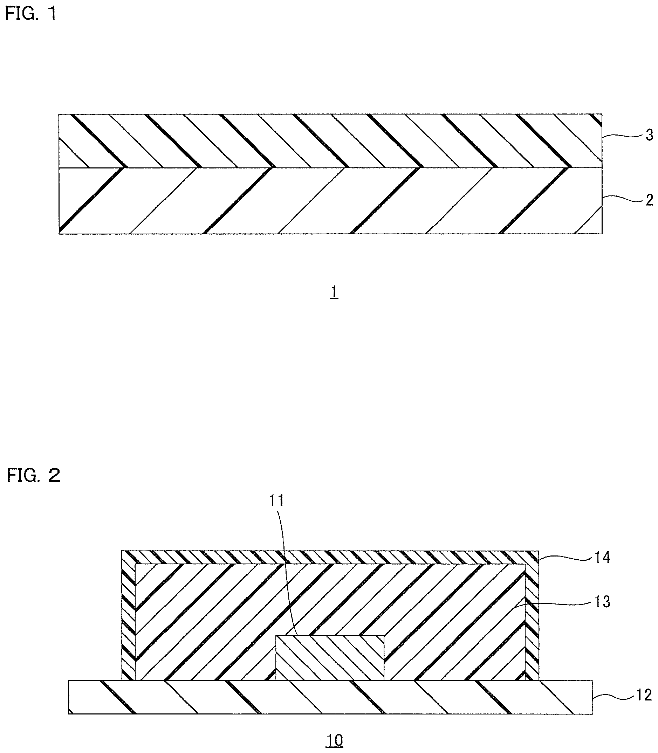

In FIG. 1, a multi-layered sheet 1 does not include an adhesive layer on an uppermost surface and includes a substrate sheet 2 and a protective layer 3 disposed on one surface of the substrate sheet 2.

Examples of the substrate sheet 2 include: olefin films such as a polyethylene film, a polypropylene film, a poly-1-butene film, a poly-4-methyl-1-pentene film, an ethylene-propylene copolymer film, an ethylene-1-butene copolymer film, an ethylene-vinyl acetate copolymer film, an ethylene-ethyl acrylate copolymer film, and an ethylene-vinyl alcohol copolymer film; polyester films such as a polyethylene terephthalate film, a polyethylene naphthalate film, and a polybutylene telephthalate film; polyamide films such as a nylon 6 film, a nylon 6,6 film, and a partially aromatic polyamide film; chlorine-based films such as a polyvinyl chloride film, and a polyvinylidene chloride film; fluorinated films such as an ETFE (tetrafluoroethylene-ethylene copolymer) film; and others, for example, plastic films such as a poly(meta)acrylate film, a polystyrene film, and a polycarbonate film.

The substrate sheet 2 can be produced as, for example, a non-oriented film or an oriented film such as a uniaxial oriented film or a biaxial oriented film.

Further, if necessary, the substrate sheets 2 can be subjected to an easily adhesive treatment such as a release treatment using a mold release agent such as a silicone-based, fluorinated, long-chain alkyl-based, or fatty acid amide-based mold release agent, or a silica powder, a stain-resistant treatment, an acid treatment, an alkali treatment, a primer treatment, a corona treatment, a plasma treatment, an ultraviolet treatment, or an electron-beam treatment, or antistatic treatment such as vapor-deposition, spraying, or kneading.

As the substrate sheet 2, preferably, an olefin film, and a fluorinated film are used. And more preferably, an olefin film is used.

The substrate sheet 2 has a thickness of, for example, 5 $\mu$m or more, preferably 10 $\mu$m or more, and for example, 300 $\mu$m or less, preferably 100 $\mu$m or less.

The protective layer 3 is an uppermost layer of the multi-layered sheet 1. As described below, the protective layer 3 is provided to protect at least a part of the surface of the mold resin (described below). That is, the protective layer 3 is exposed as the uppermost surface (top surface in FIG. 1) of the multi-layered sheet 1 so that the protective layer 3 can be in contact with the mold resin (described below).

The protective layer 3 is made of an active energy ray-curable resin. More specifically, the protective layer 3 includes a product of an active energy ray-curable resin cured or half-cured by the active energy ray. Preferably, the protective layer 3 consists of a product of an active energy ray-curable resin cured or half-cured by the active energy ray (a half-cured product produced by the reaction of a part of an active energy ray-curable group.)

The active energy ray-curable resin contains, for example, a thermally reactive group, a polysiloxane chain, and an active energy ray-curable group. The thermally reactive group is allowed to react and thermally cure with the thermally uncured mold resin below described (that is, the material composition of the mold resin) and/or the half-thermally cured mold resin (that is, a molded product of the half-thermally cured material composition).

The thermally reactive group (hereinafter, referred to as a "protective layer-side thermally reactive group") is a functional group capable of bonding to the thermally reactive group of the thermally uncured and/or half-thermally cured mold resin (hereinafter, referred to as a "mold-side thermally reactive group").

More specifically, examples of the protective layer-side thermally reactive group include a hydroxy group (hydroxyl group), an epoxy group (glycidyl group), a carboxy group, an isocyanate group, an oxetane group, a primary amino group, and a secondary amino group.

These protective layer-side thermally reactive group are appropriately selected depending on the type of the mold-side thermally reactive group.

For example, when the mold-side thermally reactive group (described below) includes an epoxy group, examples of the protective layer-side thermally reactive group include a hydroxyl group (hydroxy group), an epoxy group (glycidyl group), a carboxy group, an isocyanate group, an oxetane group, a primary amino group, and a secondary amino group.

Alternatively, for example, when the mold-side thermally reactive group (described below) includes a hydroxyl group, examples of the protective layer-side thermally reactive group include a hydroxyl group (hydroxy group), an epoxy group (glycidyl group), a carboxy group, and an isocyanate group.

Alternatively, for example, when the mold-side thermally reactive group (described below) includes a carboxy group, examples of the protective layer-side thermally reactive group include a hydroxyl group (hydroxy group) and an epoxy group (glycidyl group).

Alternatively, for example, when the mold-side thermally reactive group (described below) includes an isocyanate group, examples of the protective layer-side thermally reactive group include a hydroxyl group (hydroxy group) and an epoxy group (glycidyl group).

These protective layer-side thermally reactive groups may be used singly or in combination of two or more.

The average molarity of the protective layer-side thermally reactive group contained in the active energy ray-curable resin is appropriately set depending on the purpose and intended use.

A polysiloxane chain is introduced in the active energy ray-curable resin to ensure the non-adherence of the protective layer 3 to the molding tool (or that the molding tool is uncontaminated).

More specifically, a polysiloxane chain is a repetition unit in terms of which a dialkyl siloxane structure ($-(R_2Sio)-$(R: an alkyl group with carbons of 1 to 4)) is repeated. The polysiloxane chain is contained in the main chain and/or side chains of the active energy ray-curable resin. Preferably, the polysiloxane chain is contained in the side chains of the active energy ray-curable resin.

In other words, the active energy ray-curable resin preferably contains a polysiloxane side chain.

The repetition unit of a siloxane structure ($-(R_2Sio)-$) in a polysiloxane chain is not particularly limited and is appropriately set according to the purpose and intended use. The repetition unit of a siloxane structure ($-(R_2Sio)-$) is, for example, 10 or more, preferably 100 or more, and for example, 300 or less, preferably 200 or less.

The average molarity of the polysiloxane chain contained in the active energy ray-curable resin is appropriately set according to the purpose and intended use.

The active energy ray-curable group is a group to be reacted and cured by the irradiation of active energy ray (described below). Examples of the active energy ray-curable group include a (meth) acryloyl group.

The "(meth) acryloyl group" is defined as an "acryloyl group" and/or a "methacryloyl group".

Similarly, the "(meth)acryl" described below is defined as "acryl" and/or "methacryl". The "(meth)acrylate" is defined as "acrylate" and/or "methacrylate".

The active energy ray-curable group is preferably a (meth)acryloyl group.

That is, the active energy ray-curable resin preferably contains a (meth)acryloyl group as the active energy ray-curable group. In other words, for the active energy ray-curable resin, preferably, a (meth)acrylic resin is used.

The average molarity of the active energy ray-curable group contained in the active energy ray-curable resin is appropriately set according to the purpose and intended use.

For easy production, as the active energy ray-curable resin, preferably, a (meth)acrylic resin having the protective layer-side thermally reactive group, a polysiloxane chain (main chain or side chain), and the active energy ray-curable group are used. More preferably, a (meth)acrylic resin having the protective layer-side thermally reactive group, a polysiloxane side chain, and the active energy ray-curable group are used.

To produce the (meth)acrylic resin having the protective layer-side thermally reactive group, a polysiloxane side chain, and the active energy ray-curable group, for example, as following, the (meth)acrylic resin having a protective layer-side thermally reactive group and a polysiloxane chain without an active energy ray-curable group (hereinafter, referred to as an "intermediate polymer") is first produced, and the active energy ray-curable group is subsequently introduced into the produced intermediate polymer.

More specifically, in this method, polymerizable components including a polysiloxane-containing compound and a thermally reactive group-containing compound are first polymerized to produce a polymer (intermediate polymer) without an active energy ray-curable group.

Examples of the polysiloxane-containing compound include a compound having a polysiloxane group and a (meth)acryloyl group in combination.

More specifically, examples of the polysiloxane-containing compound include a polysiloxane group-containing (meth)acrylic compound such as 3-(meth) acryloylpropyldimethylpolysiloxane or 3-(meth)acryloylpropylphenylmethylpolysiloxane.

These polysiloxane-containing compounds may be used singly or in combination of two or more.

For the polysiloxane-containing compound, preferably, 3-(meth) acryloylpropyldimethylpolysiloxane is used. More preferably, 3-meth acryloylpropyldimethylpolysiloxane is used.

The content of the polysiloxane-containing compound relative to a total amount of the polymerizable component is, for example, 0.05 mass% or more, preferably 0.1 mass% or more, and for example, 20 mass% or less, preferably 10 mass% or less.

Examples of the thermally reactive group-containing compound include a hydroxyl group-containing polymerizable compound, an epoxy group-containing polymerizable compound, a carboxy group-containing polymerizable compound, an isocyanate group-containing polymerizable compound, an oxetane group-containing polymerizable compound, and a primary amino group-containing polymerizable compound, and a secondary amino group-containing polymerizable compound.

Examples of the hydroxyl group-containing polymerizable compound include hydroxyl group-containing (meth)acrylate compounds such as hydroxymethyl (meth)acrylate, 2-hydroxyethyl (meth)acrylate, 3-hydroxypropyl (meth)acrylate, 1-methyl-2-hydroxyethyl (meth)acrylate, 2-hydroxypropyl (meth)acrylate, and 4-hydroxybutyl (meth)acrylate. These can be used singly, or can be used in combination of two or more.

Examples of the epoxy group-containing polymerizable compound include epoxy group-containing (meth)acrylic compounds such as glycidyl (meth)acrylate. These can be used singly, or can be used in combination of two or more.

Examples of the carboxy group-containing polymerizable compound include $\alpha,\beta$-unsaturated carboxylic acids such as (meth)acrylic acid, itaconic acid, maleic acid, and fumaric acid or a salt thereof.

These can be used singly, or can be used in combination of two or more.

Examples of the isocyanate group-containing polymerizable compound include isocyanate group-containing (meth)acrylic compounds such as isocyanatomethyl (meth)acrylate, 2-isocyanatoethyl (meth)acrylate, 3-isocyanatopropyl (meth)acrylate, 1-methyl-2-isocyanatoethyl (meth)acrylate, 2-isocyanatopropyl (meth)acrylate, and 4-isocyanatobutyl (meth)acrylate. These can be used singly, or can be used in combination of two or more.

Examples of the oxetane group-containing polymerizable compound include oxetane group-containing (meth)acrylic compounds such as (3-ethyloxetane-3-yl)methyl (meth)acrylate. These can be used singly, or can be used in combination of two or more.

Examples of the primary amino group-containing polymerizable compound include primary amino group-containing (meth)acrylic compounds such as aminoethyl (meth)acrylate and aminopropyl (meth)acrylate. These can be used singly, or can be used in combination of two or more.

Examples of the secondary amino group-containing polymerizable compound include secondary amino group-containing (meth)acrylic compounds such as monomethylaminoethyl (meth)acrylate, monobutylaminoethyl (meth)acrylate, monomethylaminopropyl (meth)acrylate, and monobutylaminopropyl (meth)acrylate.

These thermally reactive group-containing compounds can be used singly, or can be used in combination of two or more.

For the thermally reactive group-containing compound, preferably, a hydroxyl group-containing polymerizable compound, an epoxy group-containing polymerizable compound, and a carboxy group-containing polymerizable compound are used.

The content of the thermally reactive group-containing compound relative to a total amount of the polymerizable component is, for example, 30 mass% or more, preferably 50 mass% or more, and for example, 90 mass% or less, preferably 80 mass% or less.

The polymerizable component can further include another polymerizable compound containing neither a polysiloxane chain nor a thermally reactive group (hereinafter, referred to as "other polymerizable compounds").

Examples of the other polymerizable compounds include (meth)acrylic acid ester and an aromatic ring-containing polymerizable compound.

Examples of the (meth)acrylic acid ester include a straight-chain, branched, or cyclic alkyl (meth)acrylate monomer having 1 to 30 carbon atoms such as methyl (meth)acrylate, ethyl (meth)acrylate, n-propyl (meth)acrylate, isopropyl (meth)acrylate, n-butyl (meth)acrylate, isobutyl (meth)acrylate, s-butyl (meth)acrylate, t-butyl (meth)acrylate, pentyl (meth)acrylate, neopentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, isononyl (meth)acrylate, decyl (meth)acrylate, dodecyl (meth)acrylate, tridecyl (meth)acrylate, tetradecyl (meth)acrylate, 1-methyltridecyl (meth)acrylate, hexadecyl (meth)acrylate, octadecyl (meth)acrylate (stearyl (meth)acrylate), isostearyl (meth)acrylate, eicosyl (meth)acrylate, docosyl (meth)acrylate (behenyl (meth)acrylate), tetracosyl (meth)acrylate, triacontyl (meth)acrylate, and cyclohexyl (meth)acrylate. These can be used singly, or can be used in combination of two or more.

Examples of the aromatic ring-containing polymerizable compound include an aromatic ring-containing (meth)acrylate such as phenyl (meth)acrylate, benzyl (meth)acrylate, phenoxyethyl (meth)acrylate, (meth)acrylic acid phenoxydiethylene glycol, o-phenylphenoxyethyl (meth)acrylate, and phenoxybenzyl (meth)acrylate, and a styrene-based monomer such as styrene and $\alpha$-methylstyrene. These can be used singly, or can be used in combination of two or more.

For the other polymerizable compounds, preferably, (meth)acrylic acid ester is used.

The content of another polymerizable compound relative to a total amount of the polymerizable component is, for example, 20 mass% or more, preferably 30 mass% or more, and for example, 60 mass% or less, preferably 50 mass% or less.

To polymerize the polymerizable components, for example, the above-described polymerizable component is mixed at the above-described ratio in a solvent, is heated and polymerized under the presence of a known radical polymerization initiator (for example, an azo-based compound, or a peroxide compound).

Examples of the solvent are not particularly limited as long as the solvent is stable with the polymerizable component. Examples of the solvent include organic solvents such as petroleum-based hydrocarbon solvents including hexane and mineral spirit; aromatic hydrocarbon solvents including benzene, toluene, and xylene; ketone solvents including acetone, methyl ethyl ketone, methyl isobutyl ketone, diisobutyl ketone, and cyclohexanone; ester solvents including methyl acetate, ethyl acetate, butyl acetate, γ-butyrolactone, and propylene glycol monomethyl ether acetate; and non-protonic polar solvents including N,N-dimethylformamide, N,N-dimethylacetoamide, dimethylsulfoxide, N-methylpyrrolidone, and pyridine.

Further, examples of the solvent include aqueous solvents such as water; alcohol solvents including methanol, ethanol, propanol, isopropanol, and butanol; and glycol ether solvents including ethylene glycol monoethyl ether and propylene glycol monomethyl ether.

As the solvent, a commercially available product is also used. To be specific, as the petroleum-based hydrocarbon solvent, for example, AF Solvent No. 4 to No. 7 (hereinabove, manufactured by Nippon Oil Corporation) are used and as the aromatic hydrocarbon solvent, for example, Ink Solvent No. 0 (hereinabove, manufactured by Nippon Oil Corporation) and Solvesso 100, 150, and 200 manufactured by Exxonmobil Corporation are used.

These solvents may be used singly or in combination of two or more.

The mixing ratio of the solvent is not particularly limited, and is appropriately set according to the purpose and intended use.

The polymerization conditions differ depending on the formulation of the polymerizable component or the type of the radical polymerization initiator. For example, the polymerization temperature is 30°C or higher, preferably 60°C or higher, and for example, 150°C or lower, preferably 120°C or lower. The polymerization time is, for example, 2 hours or longer, preferably 4 hours or longer, and for example, 20 hours or shorter, preferably 8 hours or shorter.

In this manner, as the intermediate polymer, a (meth)acrylic resin without the active energy ray-curable group is produced.

In other words, the intermediate polymer is a reaction product of an intermediate material component (a primary material component) that includes the polysiloxane-containing compound and the thermally reactive group-containing compound and does not include the active energy ray-curable group-containing compound.

Preferably, the intermediate polymer is produced as a solution and/or dispersion.

In such a case, the solid content (non-volatile content) concentration of the solution and/or dispersion of the intermediate polymer is, for example, 5 mass% or more, preferably 10 mass% or more, and for example, 60 mass% or less, preferably 50 mass% or less.

Further, if necessary, the solvent is added or removed so that the solid content (non-volatile content) concentration of the intermediate polymer can be adjusted in the above-described range, and thus the viscosity of the solvent and/or dispersion of the intermediate polymer can be adjusted.

The viscosity (25°C) of the 30 mass% solvent of the intermediate polymer is, for example, 1 mPa· s or more, preferably 5 mPa· s or more, and for example, 800 mPa· s or less, preferably 400 mPa· s or less.

The measuring method of the viscosity is in accordance with Examples described below (the same applies hereinafter).

Further, the weight-average molecular weight (GPC measurement: in the conversion to polystyrene) of the intermediate polymer is, for example, 5000 or more, preferably 10000 or more, and for example, 100000 or less, preferably 50000 or less.

Further, the number-average molecular weight (GPC measurement: in the conversion to polystyrene) of the intermediate polymer is, for example, 1000 or more, preferably 5000 or more, and for example, 50000 or less, preferably 30000 or less.

The measuring methods of the weight-average molecular weight and the number-average molecular weight is in accordance with Examples described below (the same applies hereinafter).

For the abrasion-resistance (described below), the glass transition temperature of the intermediate polymer is, for example, 0°C or higher, preferably 5°C or higher, more preferably 15°C or higher, even more preferably 20°C or higher, and for example, 70°C or lower, preferably 60°C or lower, more preferably 45°C or lower, even more preferably 35°C or lower.

The measuring method of the glass transition temperature of the intermediate polymer is in accordance with Examples described below (the same applies hereinafter).

Furthermore, the acid value of the intermediate polymer is, for example, 0.01 mgKOH/g or more, preferably 0.05 mgKOH/g or more, and for example, 200 mgKOH/g or less, preferably 100 mgKOH/g or less.

The measuring method of the acid value of the intermediate polymer is in accordance with Examples described below (the same applies hereinafter).

Alternatively, when the polymerizable component contains the hydroxyl group-containing polymerizable compound, the hydroxyl value of the intermediate polymer is, for example, 10 mgKOH/g or more, preferably 20 mgKOH/g or more, and for example, 90 mgKOH/g or less, preferably 80 mgKOH/g or less.

Note that the measuring method of the hydroxyl value is in accordance with the examples described below (the same applies hereinafter).

Alternatively, when the polymerizable component contains the epoxy group-containing polymerizable compound, the epoxy equivalent of the intermediate polymer is, for example, 300 g/eq or more, preferably 500 g/eq or more, and for example, 2000 g/eq or less, preferably 1500 g/eq or less.

The measuring method of the epoxy equivalent is in accordance with Examples described below (the same applies hereinafter).

Next, in this method, the intermediate polymer produced as described above is reacted with the active energy ray-curable group-containing compound to introduce the active energy ray-curable group into the intermediate polymer. This produces the (meth)acrylic resin having the active energy ray-curable group in its side chain.

Examples of the active energy ray-curable group-containing compound include the above-described hydroxyl group-containing (meth)acrylic compound, the above-described epoxy group-containing (meth)acrylic compound, the above-described α,β-unsaturated carboxylic acid, the above-described isocyanate group-containing (meth)acrylic compound, the above-described oxetane group-containing (meth)acrylic compound, the above-described primary amino group-containing (meth)acrylic compound, and the above-described secondary amino group-containing (meth)acrylic compound.

These can be used singly, or can be used in combination of two or more.

The active energy ray-curable group-containing compound is appropriately selected according to the thermally reactive group included in the intermediate polymer.

That is, the active energy ray-curable group-containing compound reacts with a part of the thermally reactive group included in the intermediate polymer and they bond to each other. This introduces the active energy ray-curable group into the intermediate polymer and consequently produces the active energy ray-curable resin.

Accordingly, in this method, the active energy ray-curable group-containing compound having a functional group (thermally reactive group) bondable to the thermally reactive group in the intermediate polymer is selected.

For example, when the intermediate polymer contains the epoxy group as the thermally reactive group, a functional group (reactive group) capable of reacting with the epoxy group is selected as the thermally reactive group in the active energy ray-curable group-containing compound. Specific examples of such an active energy ray-curable group include a hydroxyl group, an epoxy group, a carboxy group, an isocyanate group, an oxetane group, a primary amino group, and a secondary amino group. Meanwhile, an active energy ray-curable group-containing compound having a functional group (reactive group) capable of reacting with the epoxy group is selected as the active energy ray-curable group-containing compound. Specific examples of the active energy ray-curable group-containing compound include a hydroxyl group-containing (meth)acrylic compound, an epoxy group-containing (meth)acrylic compound, α,β-unsaturated carboxylic acid, an isocyanate group-containing (meth)acrylic compound, an oxetane group-containing (meth)acrylic compound, a primary amino group-containing (meth)acrylic compound, and a secondary amino group-containing (meth)acrylic compound, and preferably α,β-unsaturated carboxylic acid is used.

Alternatively, when the intermediate polymer contains a hydroxyl group as the thermally reactive group, examples of the thermally reactive group in the active energy ray-curable group-containing compound include a hydroxyl group, an epoxy group, a carboxy group, and an isocyanate group. Meanwhile, examples of the active energy ray-curable group-containing compound include a hydroxyl group-containing (meth)acrylic compound, an epoxy group-containing (meth)acrylic compound, α,β-unsaturated carboxylic acid, and an isocyanate group-containing (meth)acrylic compound. Preferably an isocyanate group-containing (meth)acrylic compound is used.

Alternatively, when the intermediate polymer contains a carboxy group as the thermally reactive group, examples of the thermally reactive group in the active energy ray-curable group-containing compound include a hydroxyl group and an epoxy group. Meanwhile, examples of the active energy ray-curable group-containing compound include a hydroxyl group-containing (meth)acrylic compound and an epoxy group-containing (meth)acrylic compound. Preferably, an epoxy group-containing (meth)acrylic compound is used.

Alternatively, when the intermediate polymer contains an isocyanate group as the thermally reactive group, examples of the thermally reactive group in the active energy ray-curable group-containing compound include a hydroxyl group and an epoxy group. Meanwhile, examples of the active energy ray-curable group-containing compound include a hydroxyl group-containing (meth)acrylic compound and an epoxy group-containing (meth)acrylic compound. Preferably a hydroxyl group-containing (meth)acrylic compound is used.

The active energy ray-curable group-containing compound selected as described above bonds to a part of the thermally reactive group in the intermediate polymer. This introduces the active energy ray-curable group into the intermediate polymer.

The mixing ratio of the active energy ray-curable group-containing compound is appropriately selected so that the thermally reactive group in the intermediate polymer remains unreacted (free).

More specifically, relative to 100 moles of the thermally reactive group in the intermediate polymer, the thermally reactive group in the active energy ray-curable group-containing compound is, for example, 10 moles or more, preferably 20 moles or more, and for example, 90 moles or less, preferably 80 moles or less.

In the reaction at the ratio described above, the thermally reactive group in the intermediate polymer remains without bonding to the thermally reactive group in the active energy ray-curable group-containing compound.

As a result, the thermally reactive group remaining in the intermediate polymer ensures its thermally reactive property with a thermally uncured and/or half-thermally cured mold resin described below.

In the reaction of the intermediate polymer with the active energy ray-curable group-containing compound, for example, the intermediate polymer is blended with the active energy ray-curable group-containing compound so that the thermally reactive group in the intermediate polymer is blended with the thermally reactive group in the active energy ray-curable group-containing compound at the above-described ratio. Then, the mixture is heated under the presence of known catalyst and solvent if necessary.

Examples of the catalyst include tin-based catalysts such as dibutyltin dilaurate, dioctyltin laurate, and dioctyltin dilaurate, and organophosphate catalysts such as triphenylphosphine. These can be used singly, or can be used in combination of two or more.

The mixing ratio of the catalyst is not particularly limited and is appropriately set depending on the purpose and intended use.

For the reaction conditions in air atmosphere, for example, the reaction temperature is, for example, 40°C or higher, preferably 60°C or higher, and for example, 200°C or lower, preferably 150°C or lower. Meanwhile, the reaction time is, for example, 1 hour or longer, preferably 2 hours or longer, and for example, 20 hours or shorter, preferably 12 hours or shorter.

In this reaction, a polymerization inhibitor can be added as necessary.

Examples of the polymerization inhibitor include: phenol compounds such as p-methoxyphenol, hydroquinone, hydroquinone monomethyl ether, catechol, tert-butylcatechol, 2,6-di-tert-butyl-hydroxytoluene, 4-tert-butyl-1,2-dihydroxybenzene, and 2,2'-methylene-bis(4-methyl-6-tert-buthylcatechol); aromatic amines such as phenothiazine, diphenyl phenylenediamine, dinaphthyl phenylenediamine, p-aminodiphenylamine, and N-alkyl-N'-Phenylenediamine; N-oxyl derivatives such as 4-hydroxy-2,2,6,6-tetramethylpiperidine, 4-acetoxy-1-oxy-2,2,6,6-tetramethylpiperidine, 4-benzoyloxy-1-oxy-2,2,6,6-tetramethylpiperidine, 4-alkoxy-1-oxy-2,2,6,6-tetramethylpiperidine, bis(-1-oxy-2,2,6,6-tetramethylpiperidine-4-il) sebacate, and 2,2,6,6-tetramethylpiperidine; N-nitrosodiphenylamine; copper salt of diethyldithiocarbamic acid; and p-benzoquinone.

These can be used singly, or can be used in combination of two or more.

For the polymerization inhibitor, preferably, p-methoxyphenol is used.

The mixing ratio of the polymerization inhibitor is, relative to 100 parts by mass of a total amount of the intermediate polymer and active energy ray-curable group-containing compound, for example, 0.0001 parts by mass or more, preferably 0.01 parts by mass or more, and for example, 1.0 part by mass or less, preferably 0.1 parts by mass or less.

In this manner, a part of the thermally reactive group in the intermediate polymer reacts with the corresponding thermally reactive group in the active energy ray-curable group-containing compound and the active energy ray-curable group-containing compound bonds to a side chain of the intermediate polymer. Thus, the active energy ray-curable group (preferably, (meth)acryloyl group) is introduced into the terminal of the side chain.

More specifically, when the intermediate polymer contains an epoxy group as the thermally reactive group and the active energy ray-curable group-containing compound is $\alpha,\beta$-unsaturated carboxylic acid, the esterification reaction of the epoxy group with the carboxy group introduces the active energy ray-curable group into the intermediate polymer.

Alternatively, when the intermediate polymer contains a carboxy group as the thermally reactive group and the active energy ray-curable group-containing compound is a hydroxyl group-containing (meth)acrylic compound, the esterification reaction of the carboxy group with the epoxy group introduces the active energy ray-curable group into the intermediate polymer.

Alternatively, when the intermediate polymer contains a hydroxyl group as the thermally reactive group and the active energy ray-curable group-containing compound is an isocyanate group-containing (meth)acrylic compound, the urethanization reaction of the hydroxyl group with the isocyanate group introduces the active energy ray-curable group into the intermediate polymer.

Alternatively, when the intermediate polymer contains an isocyanate group as the thermally reactive group and the active energy ray-curable group-containing compound is a hydroxyl group-containing (meth)acrylic compound, the urethanization reaction of the isocyanate group with the hydroxyl group introduces the active energy ray-curable group into the intermediate polymer.

As a result, the active energy ray-curable resin (having a protective layer-side thermally reactive group, a polysiloxane chain, and an active energy ray-curable group) is produced.

That is, the active energy ray-curable resin is a reaction product of the material component (secondary material component) including the polysiloxane-containing compound, thermally reactive group-containing compound, and active energy ray-curable group-containing compound.

In the production of the above-described active energy ray-curable resin, a part of the thermally reactive group in the intermediate polymer is an introduction group for introducing the active energy ray-curable group into the intermediate polymer side chain. The rest of the thermally reactive group (hereinafter, the remaining thermally reactive group) is a protective layer-side thermally reactive group for reacting with the mold material in a thermally uncured and/or half-thermally cured state (described below).

Alternatively, when the intermediate polymer contains an epoxy group as the introduction group, the ring-opening of the epoxy group generates a hydroxyl group in the reaction of the epoxy group with the active energy ray-curable group-containing compound (for example, $\alpha,\beta$-unsaturated carboxylic acid). Such a hydroxyl group is also the protective layer-side thermally reactive group and contributes to the thermal reaction with the thermally uncured and/or half-thermally cured mold resin described below.

Alternatively, as necessary, in the introduction of the active energy ray-curable group, the hydroxyl group generated by the ring-opening of the epoxy group can also be used as an introduction group for introducing another active energy ray-curable group.

Relative to a total amount of the non-volatile content in the material component of the active energy ray-curable resin (a total amount of the non-volatile content of the polymerizable component in the intermediate polymer and the active energy ray-curable group-containing compound (the same applies hereinafter)), the content of the polysiloxane-containing compound is, for example, 0.05 mass% or more, preferably 0.10 mass% or more, and for example, 20.0 mass% or less, preferably 10.0 mass% or less.

Meanwhile, relative to a total amount of the non-volatile content in the material component of the active energy ray-curable resin, the content of the thermally reactive group-containing compound is, for example, 30 mass% or more, preferably 50 mass% or more, and for example, 90 mass% or less, preferably 80 mass% or less.

Meanwhile, relative to the total amount of the non-volatile content in the material component of the active energy ray-curable resin, the content of another polymerizable compound is, for example, 10 mass% or more, preferably 20 mass% or more, and for example, 60 mass% or less, preferably 50 mass% or less.

Meanwhile, relative to a total amount of the non-volatile content in the material component of the active energy ray-curable resin, the content of the active energy ray-curable group-containing compound is, for example, 5 mass% or more, preferably 10 mass% or more, and for example, 40 mass% or less, preferably 30 mass% or less.

The ratio of the remaining thermally reactive group, the polysiloxane chain, and the active energy ray-curable group in the active energy ray-curable resin is appropriately set according to the purpose and intended use.

More specifically, for the tight contact with the mold resin, in 1 g of the active energy ray-curable resin, the remaining thermally reactive group is, for example, 0.02 mmol or more, preferably 0.04 mmol or more, and for example, 4.0 mmol or less, preferably 3.0 mmol or less.

Meanwhile, for the uncontaminated condition of the molding tool, in 1 g of the active energy ray-curable resin, the polysiloxane chain is, for example, 0.00010 mmol or more, preferably 0.0060 mmol or more, and for example, 0.020 mmol or less, preferably 0.010 mmol or less.

Meanwhile, for the abrasion-resistance (described below), in 1 g of the active energy ray-curable resin, the active energy ray-curable group is, for example, 0.5 mmol or more, preferably 1.0 mmol or more, and more preferably 1.5 mmol or more. Further, for the tensile elongation, the active energy ray-curable group is, for example, 5.0 mmol or less, preferably 3.5 mmol or less.

Meanwhile, the molar ratio of the remaining thermally reactive group to the polysiloxane chain (remaining thermally reactive group/polysiloxane chain) is, for example, 50 or more, preferably 100 or more, more preferably 150 or more, and for example, 15000 or less, preferably 10000 or less, more preferably 1000 or less, even more preferably 400 or less.

Meanwhile, the molar ratio of the remaining thermally reactive group to the active energy ray-curable group (remaining thermally reactive group/active energy ray-curable group) is, for example, 0.1 or more, preferably 0.5 or more, and for example, 3.0 or less, preferably 1.0 or less.

Meanwhile, the molar ratio of the active energy ray-curable group to the polysiloxane chain (active energy ray-curable group/polysiloxane chain) is, for example, 100 or more, preferably 200 or more, and for example, 15000 or less, preferably 10000 or less.

Preferably, the active energy ray-curable resin is produced as a solution and/or dispersion.

In such a case, the solid content (non-volatile content) concentration of the solution and/or dispersion of the active energy ray-curable resin is, for example, 5 mass% or more, preferably 10 mass% or more, and for example, 60 mass% or less, preferably 50 mass% or less.

Further, if necessary, the solvent is added or removed so that the solid content (non-volatile content) concentration of the active energy ray-curable resin can be adjusted in the above-described range, and thus the viscosity of the solvent and/or dispersion of the active energy ray-curable resin can be adjusted.

For example, the viscosity (25 °C) of a 30 %mass solution of the active energy ray-curable resin is, for example, 5 mPa·s or more, preferably 10 mPa·s or more, and for example, 800 mPa·s or less, preferably 400 mPa·s or less.

Meanwhile, for the abrasion-resistance (described below), the weight-average molecular weight (GPC measurement: in the conversion to polystyrene) of the active energy ray-curable resin is, for example, 5000 or more, and preferably 10000 or more. For the tensile elongation, the weight-average molecular weight is of the active energy ray-curable resin, for example, 100000 or less, preferably 50000 or less.

Meanwhile, for the abrasion-resistance (described below), the number-average molecular weight (GPC measurement: in the conversion to polystyrene) of the active energy ray-curable resin is, for example, 2000 or more, and preferably 5000 or more. For the tensile elongation, the number-average molecular weight of the active energy ray-curable resin is, for example, 50000 or less, preferably 20000 or less.

For the abrasion-resistance (described below), the glass transition temperature of the active energy ray-curable resin is, for example, 0°C or more, preferably 5 °C or more. For the tensile elongation, the glass transition temperature of the active energy ray-curable resin is, for example, 70°C or less, preferably 60 °C or less.

For the abrasion-resistance (described below), the acid value of the active energy ray-curable resin is, for example, 0.1 mgKOH/g or more, preferably 0.5 mgKOH/g or more. For the tensile elongation, the acid value of the active energy ray-curable resin is, for example, 200 mgKOH/g or less, preferably 100 mgKOH/g or less.

Particularly, a higher acid value is preferable for the abrasion-resistance (described below). Specifically, the acid value is preferably 10 mgKOH/g or more, more preferably 20 mgKOH/g or more, even more preferably 40 mgKOH/g or more, particularly preferably 60 mgKOH/g or more.

On the other hand, a lower acid value is preferable for the tensile elongation. Specifically, the acid value is preferably 60 mgKOH/g or less, more preferably 40 mgKOH/g or less, even more preferably 20 mgKOH/g or less, particularly preferably 10 mgKOH/g or less.

Furthermore, the hydroxyl value of the active energy ray-curable resin is, for example, 10 mgKOH/g or more, more preferably 20 mgKOH/g or more, and for example, 90 mgKOH/g or less, preferably 80 mgKOH/g or less.

Particularly, a higher hydroxyl value is preferable for the abrasion-resistance (described below). Specifically, the hydroxyl value is preferably 10 mgKOH/g or more, even more preferably 20 mgKOH/g or more, even more preferably 30 mgKOH/g or more, and particularly preferably 40 mgKOH/g or more.

On the other hand, a lower hydroxyl value is preferable for the tensile elongation. Specifically, the hydroxyl value is preferably 60 mgKOH/g or less, more preferably 50 mgKOH/g or less, even more preferably 40 mgKOH/g or less, and particularly preferably 30 mgKOH/g or less.

The epoxy equivalent of the active energy ray-curable resin is, for example, 500 g/eq or more, preferably 1000 g/eq or more, and for example 20000 g/eq or less, preferably 10000 g/eq or less.

Particularly, a higher epoxy equivalent is preferable for the abrasion-resistance (described below). Specifically, the epoxy equivalent is preferably 1000 g/eq or more, even more preferably 2000 g/eq or more, even more preferably 4000 g/eq or more, and particularly preferably, 10000 g/eq or more.

On the other hand, a lower epoxy equivalent is preferable for the tensile elongation. Specifically, the epoxy equivalent is preferably 10000 g/eq or less, more preferably 5000 g/eq or less, even more preferably 3000 g/eq or less, and particularly preferably 2000 g/eq or less.

For the tensile elongation, the (meth)acryloyl equivalent of the active energy ray-curable resin is, for example, 50 g/eq or more, more preferably 100 g/eq or more, even more preferably 200 g/eq or more, particularly preferably 300 g/eq or more. For the abrasion-resistance (described below), the (meth)acryloyl equivalent of the active energy ray-curable resin is, for example, 2000 g/eq or less, more preferably 1500 g/eq or less, even more preferably 1000 g/eq or less, and particularly preferably 800 g/eq or less.

Then, the active energy ray-curable resin (having the protective layer-side thermally reactive group and the polysiloxane chain) produced in this manner can be used for providing the multi-layered sheet 1 that can suppress the contamination of the molding tool and allows the mold resin to adhere to the protective layer.

To produce the multi-layered sheet 1, the method is not particularly limited. However, first, a coating agent containing the active energy ray-curable resin is prepared.

The coating agent can contain the active energy ray-curable resin and the above-described solvent at an appropriate ratio.

The coating agent, as necessary, can contain a polymerization initiator.

Examples of the polymerization initiator include photopolymerization initiators such as 2,2-dimethoxy-1,2-diphenylethane-1-on, 1-hydroxycyclohexylphenylketone, 1-cyclohexylphenylketone, 2-hydroxy-2-methyl-1-phenyl-propane-1-on, 1-[4-(2-hydroxyethoxy)-phenyl]-2-hydroxy-2-methyl-1-propane-1-on,2-methyl-1-[4-(methylthio)phenyl]-2-morpholinopropane-1-on, 2-benzil-2-dimethylamino-1-(4-morpholinophenyl)-butanone-1, bis(2,4,6-trimethylbenzoyl)-phenylphosphine oxide, 2,4,6-trimethylbenzoyl-diphenyl-phosphine oxide, 4-methylbenzophenone, benzophenone, and 2-hydroxy-1-{4-[4-(2-hydroxy-2-methylpropionyl)-benzyl]phenyl}-2-methyl-propane-1-on.

The polymerization initiators may be used singly or in combination of two or more.

The mixing ratio of the polymerization initiator relative to 100 parts by mass of the active energy ray-curable resin is, for example, 0.01 parts by mass or more, preferably 0.5 parts by mass or more, and for example, 10 parts by mass or less, preferably 5 parts by mass or less.

Furthermore, various additives can be added to the coating agent as necessary. Examples of the various additives include cross-linking agents, pigments, drying agents, anticorrosive agents, plasticizers, coating film surface conditioners, antioxidants, ultraviolet absorbers, and dispersants. The content of the additive is appropriately set in accordance with the purpose and intended use.

The solid content (non-volatile content) concentration of the coating agent is, for example, 10 mass% or more, preferably 20 mass% or more, and for example, 70 mass% or less, preferably 50 mass% or less.

Next, in this method, the produced coating agent is applied and is dried on the one surface of the substrate sheet 2.

The method for applying the coating agent on the substrate sheet 2 is not particularly limited. Examples thereof include an application method using a generally available application device such as a roll coater, a bar coater, a doctor blade, a meyer bar, and an air knife and known application methods such as screen printing, offset printing, flexographic printing, brush coating, spray coating, gravure coating, and reverse gravure coating.

The coating agent can be applied on the entire surface of the substrate sheet 2, and can be applied to a part of the surface of the substrate sheet 2. For the application efficiency in application step, the coating agent is preferably applied on the entire surface of the substrate sheet 2.

For the drying conditions, the drying temperature is, for example, 40°C or more, preferably 60°C or more, and for example, 180°C or less, preferably 140°C or less. The drying time is, for example, 0.5 minutes or more, preferably 1 minute or more, and for example, 60 minutes or less, preferably 30 minutes or less.

The film thickness after the drying is, for example, 50 nm or more, preferably 500 nm or more, and for example, 30 $\mu$m or less, preferably 10 $\mu$m or less, more preferably 5 $\mu$m or less.

Thereafter, in this method, the dried coating film is irradiated with the active energy ray to cure or half-cure the active energy ray-curable resin.

Examples of the active energy ray include ultraviolet rays (UV (the wavelength of 10 nm to 400 nm)) and electron rays.

In the case of curing by the ultraviolet rays, for example, an ultraviolet ray application device having a xenon lamp, a high-pressure mercury lamp, or a metal halide lamp is used as a light source.

The ultraviolet radiation, the light volume of the ultraviolet ray application device, the arrangement of the light source, and the like are appropriately adjusted as needed.

Specifically, when a cured product in C stage is produced by curing the active energy ray-curable resin by UV irradiation in the dried coating film, the accumulated light volume of the UV radiation is, for example, 300 mJ/cm$^2$ or more, preferably 500 mJ/cm$^2$ or more, and for example 1000 mJ/cm$^2$ or less.

Alternatively, when a half-cured product in B stage is produced by curing the active energy ray-curable resin by UV irradiation in the dried coating film, the accumulated light volume of the UV radiation is, for example, 100 mJ/cm$^2$ or more, preferably 200 mJ/cm$^2$ or more, and for example less than 300 mJ/cm$^2$.

By such irradiation of the active energy ray, the active energy ray-curable resin in the dried coating film is cross-linked, thereby forming a three-dimensional structure. This produces the protective layer 3 as a cured product or half-cured product of the active energy ray-curable resin.

The protective layer 3 can be formed on the entire surface of the substrate sheet 2, and can be applied to a part of the surface of the substrate sheet 2. For the application efficiency without the alignment in application step, the protective layer 3 is preferably formed on the entire surface of the substrate sheet 2.

The thermally reactive group contained in the active energy ray-curable resin of the protective layer 3 is usually not reacted with the active energy ray, and thus maintains the reactivity after being cured (the reaction of all the active energy ray-curable groups) or half-cured (the reaction of a part of the active energy ray-curable groups) by the active energy ray.

In other words, the protective layer 3 contains the active energy ray-curable resin that is cured or half-cured by the active energy ray and simultaneously is not thermally cured yet (or, thermally uncured). Thus, the thermally reactive group allows the protective layer 3 to react and thermally cure with the thermally uncured and/or half-thermally cured mold resin described below.

Furthermore, when a half-cured product in B stage is produced by curing the active energy ray-curable resin with active energy ray as described above, the protective 3 contains a free (excess) active energy ray-curable group such as a (meth)acryloyl in addition to the thermally reactive group.

Such a free (excess) active energy ray-curable group functions as a thermally reactive group and is capable of reacting and thermally curing with the thermally uncured and/or half-thermally cured mold resin as described below. For example, when the mold-side thermally reactive group contains an allyl group, the (meth)acryloyl group functions as the protective layer-side thermally reactive group.

In other words, examples of the protective layer-side thermally reactive group include, as described above, a hydroxyl group (hydroxy group), an epoxy group (glycidyl group), a carboxy group, an isocyanate group, an oxetane group, a primary amino group, and a secondary amino group, and further include a (meth)acryloyl group.

When epoxy resin and/or silicone resin are/is preferably used as the mold resin for a semiconductor sealing material, a hydroxyl group, an epoxy group, a carboxy group, and a (meth)acryloyl group are preferably used as the corresponding protective layer-side thermally reactive group.

The protective layer-side reactive group may be used singly or in combination of two or more.

When a (meth)acryloyl group is singly used as the protective layer-side thermally reactive group, all the thermally reactive groups other than the (meth)acryloyl group (for example, a hydroxyl group (hydroxy group), an epoxy group (glycidyl group), a carboxy group, an isocyanate group, an oxetane group, a primary amino group, and a secondary amino group) in the intermediate polymer can be used as an introduction group for introducing the (meth)acryloyl group.

More specifically, first in the synthesis of the intermediate polymer, the thermally reactive group-containing compound is used at a predetermined ratio, thereby introducing the thermally reactive groups other than the (meth)acryloyl group (for example, a hydroxyl group (hydroxy group), an epoxy group (glycidyl group), a carboxy group, an isocyanate group, an oxetane group, a primary amino group, and a secondary amino group) into the intermediate polymer.

Next, the reaction of the all thermally reactive groups other than the (meth)acryloyl group with the above-described active energy ray-curable group-containing compound introduces the (meth)acryloyl group into the intermediate polymer, thereby producing the active energy ray-curable resin.

Thereafter, the active energy ray-curable resin is irradiated with the active energy ray and semicured as described above.

This produces the photo half-cured protective layer 3 by the photo-curing reaction of the part of the (meth)acryloyl group, and simultaneously keeps the rest of the (meth)acryloyl group unreacted as the protective layer-side thermally reactive group in the protective layer 3.

Further, the rest of the (meth)acryloyl group as the protective layer-side thermally reactive group can be used for self-curing without the reaction with the mold-side thermally reactive group.

That is, when the mold-side thermally reactive group has an allyl group, the (meth)acryloyl group remaining in the half-cured active energy ray-curable resin works as the protective layer-side thermally reactive group and reacts with the mold-side thermally reactive group. On the other hand, when the mold-side thermally reactive group does not have an allyl group or when the (meth)acryloyl groups exceed the allyl groups, the (meth)acryloyl groups crosslink themselves, for example, by heating and the half-cured active energy ray-curable resin is further cured.

The protective layer 3 has a thickness of, for example, 50 nm or more, preferably 0.5 $\mu$m or more, more preferably 1.0 $\mu$m or more and, for example, 30 $\mu$m or less, preferably 10 $\mu$m or less.

Furthermore, the total thickness of the multi-layered sheet 1 is, for example, 5 $\mu$m or more, preferably 10 $\mu$m or more and, for example, 300 $\mu$m or less, preferably 100 $\mu$m or less.

In the multi-layered sheet 1, the protective layer 3 includes a product of the active energy ray-curable resin cured or half-cured by the active energy ray and has the thermally reactive group (protective layer-side thermally reactive group) capable of reacting and thermally curing with the thermally reactive group (mold-side thermally reactive group) of the thermally uncured and/or half-thermally cured mold material (described below), and a polysiloxane chain.

Thus, the thermally uncured and/or half-thermally cured mold material and the protective layer 3 are brought into contact and heated, thereby chemically bonding them. Further, the thermally uncured and/or half-thermally cured mold resin is cured. Furthermore, the protective layer 3 is cured, thereby forming the hard coating layer 14 (described below).

This allows the hard coating layer 14 (described below) to adhere to the mold resin without providing an adhesive layer.

That is, in the above-described multi-layered sheet 1, the hard coating layer with excellent adhesion to the mold resin is formed. Meanwhile, the contamination of the molding tool is suppressed. Further, the hard coating layer 14 (described below) produced using the above-described multi-layered sheet 1 has the surface with excellent smoothness and thus has excellent optical properties.

Thus, the above-described multi-layered sheet 1 is suitably used in a transfer material for producing a hard coating layer-laminated mold resin.

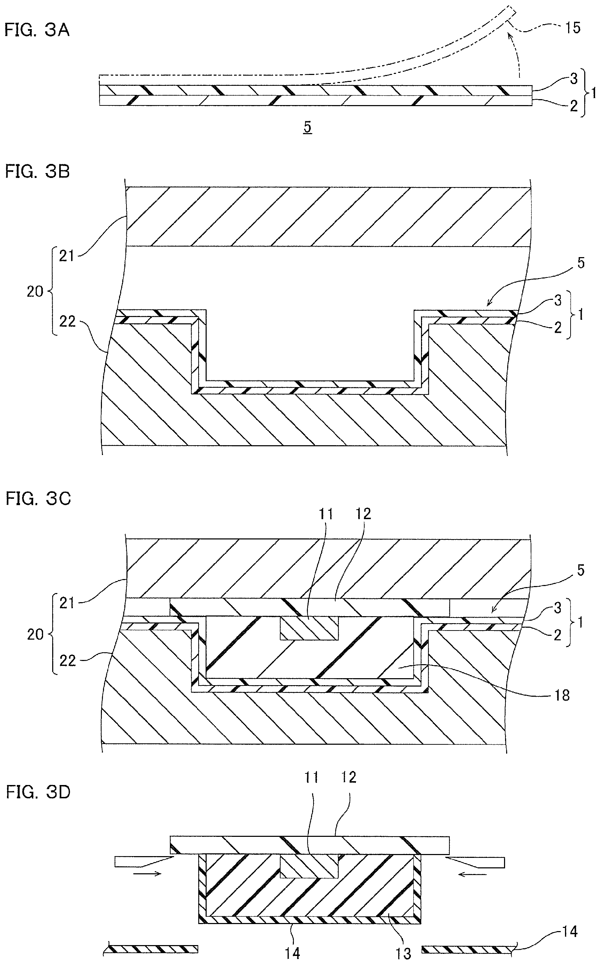

Hereinafter, with reference to FIG. 2 and FIG. 3, the transfer material, the hard coating layer-laminated mold resin and a producing method thereof will be described in detail.

In FIG. 2, a semiconductor sealing package 10 is an embodiment of the hard coating layer-laminated mold resin.

The semiconductor sealing package 10 includes a semiconductor chip 11, a substrate 12, a sealing member 13 as a mold resin that seals the semiconductor chip 11, and a hard coating layer 14 that protects at least a part of the surface (the upper surface and peripheral surfaces in FIG. 1) of the sealing member 13.

The semiconductor chip 11 is a semiconductor device sealed in the mold resin. Examples of the semiconductor device include photo semiconductor devices and integrated circuits. Preferably, a photosemiconductor device is used. More specifically, examples of the photo semiconductor devices include light receiving elements such as a photo diode and light emitting elements such as a light emitting diode. The photo semiconductor devices may be used singly or in combination of two or more.

In the semiconductor sealing package 10, the hard coating layer 14 has excellent smoothness. Thus, when a photosemiconductor device is used as the semiconductor chip 11, the semiconductor sealing package 10 has excellent optical properties.

Although not illustrated in detail, the semiconductor chip 11 is electrically connected to the substrate 12 by a known method such as flip chip bonding or wire bonding.

The sealing member 13 is mold resin molded to seal a semiconductor chip. As described below, the mold resin is produced by molding and curing thermally uncured and/or half-thermally cured mold resin.

Examples of the mold resin include know resins used as the sealing member 13. The examples thereof include epoxy resin, silicone resin, polyester resin, polycarbonate resin, phenol resin, acryl resin, diallyl phthalate resin, and polyurethane resin.

More specifically, for example, epoxy resin can be produced by thermally curing an epoxy resin composition. In such a case, the epoxy resin composition is thermally uncured mold resin (hereinafter, sometimes referred to as a "mold material"). Generally, the epoxy resin composition contains an epoxy group as the mold-side thermally reactive group.

Similarly, the silicone resin is produced by thermally curing a silicone resin composition. In such a case, the silicone resin composition is a mold material and generally contains an epoxy group, a hydroxyl group, and an allyl group as the mold-side thermally reactive group.

Similarly, the polyester resin is produced by thermally curing a polyester resin composition. In such a case, the polyester resin composition is a mold material and generally contains a hydroxyl group and a carboxy group as the mold-side thermally reactive group.

Similarly, the polycarbonate resin is produced by thermally curing a polycarbonate resin composition. In such a case, the polycarbonate resin composition is a mold material and generally contains a hydroxyl group as the mold-side thermally reactive group.

Similarly, the phenol resin is produced by thermally curing a phenol resin composition. In such a case, the phenol resin composition is a mold material and generally contains a hydroxyl group as the mold-side thermally reactive group.

Similarly, the acryl resin is produced by thermally curing an acryl resin composition. In such a case, the acryl resin composition is a mold material and generally contains a hydroxyl group, a carboxy group, and an epoxy group as the mold-side thermally reactive group.

Similarly, the diallyl phthalate resin is produced by thermally curing a diallyl phthalate resin composition. In such a case, the diallyl phthalate resin composition is a mold material and generally contains an allyl group as the mold-side thermally reactive group.

Similarly, the polyurethane resin is produced by thermally curing a polyurethane resin composition. In such a case, the polyurethane resin composition is a mold material and generally contains an isocyanate group and a hydroxyl group as the mold-side thermally reactive group.

These mold resins may be used singly or in combination of two or more.

For the sealing member 13 used for the semiconductor chip 11, preferably, epoxy resin and silicone resin are used.

The mold resin can be colored as necessary. However, for example, when the semiconductor chip 11 is a photosemiconductor device and a light emitting and/or receiving member is sealed in the mold resin, the mold resin is preferably a resin with light transmission property (total light transmittance of 90% or more). More preferably, light transmissive epoxy resin and light transmissive silicone resin are used.

The hard coating layer 14 is a protective layer with hard coating properties. The hard coating layer 14 includes has a thermally reactive group capable of reacting and thermally curing with a thermally uncured and/or half-thermally cured mold resin, and a polysiloxane chain.

The hard coating layer 14 can be produced by thermally curing the protective layer 3 in the above-described multi-layered sheet 1. Preferably, the hard coating layer 14 is a cured product produced by thermally curing the protective layer 3.

Similarly, the hard coating layer 14 can be colored as necessary. However, for example, when the semiconductor chip 11 is a light emitting diode and a light emitting member is sealed in the mold resin, the hard coating layer 14 is preferably uncolored. More preferably, the hard coating layer 14 has a light transmission property (total light transmittance of 90% or more).

The hard coating properties mean, in an abrasion-resistance test in accordance with the Examples described below, the turbidity change $\Delta E$ measured with a haze meter NDH 5000 (manufactured by Nippon Denshoku Industries Co., Ltd.) is less than 3.

The hard coating layer 14 directly adheres to the sealing member 13 without, for example, the mediation of an adhesive layer.

By the chemical bonding of a thermally reactive group of the active energy ray-curable resin (the protective layer 3 before being thermally cured) and a thermally reactive group of the thermally uncured and/or half-thermally cured mold resin, the hard coating layer 14 (protective layer 3 after being thermally cured) is connected to the sealing member 13 (mold resin after being thermally cured).

To produce the semiconductor sealing package 10, for example, as illustrated in FIG. 3A, a transfer material 5 including the above-described multi-layered sheet 1 is prepared first (transfer material preparation step).

The transfer material 5 includes the above-described multi-layered sheet 1. In other words, the transfer material 5 includes a substrate sheet 2 and a protective layer 3 disposed on the one surface of the substrate sheet 2.

Further, the transfer material 5 does not include an adhesive layer on its uppermost surface. As needed, the transfer material 5 can include a peelable layer 15 disposed on one surface of the protective layer 3 of the multi-layered sheet 1.

That is, the transfer material 5 consists of the multi-layered sheet 1 without an adhesive layer on the uppermost surface. The transfer material 5 can be in form without the peelable layer 15 (namely, form where the protective layer 3 is exposed), or in form including the multi-layered sheet 1 without an adhesive layer on the uppermost surface and including the peelable layer 15 covering the protective layer 3 (namely, form where the protective layer 3 is not exposed).

The peelable layer 15 is a flexible sheet made of resin disposed on the one surface of the protective layer 3 as illustrated with the phantom line in FIG. 3A. The peelable layer 15 covers the protective layer 3 and can be peeled from the protective layer 3 while curving from one side toward the other side.

The peelable layer 15 is peeled from the protective layer 3 when the transfer material 5 is used. In the following steps, the transfer material 5 from which the peelable layer 15 is peeled (the rest excluding the peelable layer 15) is used.

Meanwhile, although not illustrated, in this method, thermally uncured and/or half-thermally cured mold resin is prepared (resin preparation step).

In the molding of FIG. 3, preferably, thermally uncured mold resin (that is, the mold material) 18 is prepared.

Next, in this method, as illustrated in FIG. 3B, the transfer material 5 is disposed so that the protective layer 3 can be exposed (disposition step).

More specifically, in the step, the mold 20 for casting the mold material 18 is prepared first. The mold 20 is a known mold including an upper mold 21 and a lower mold 22 and designed depending on the shape of the sealing member 13.

Then, in the step, the transfer material 5 is disposed in the mold 20. More specifically, the transfer material 5 is disposed so that the substrate sheet 2 of the transfer material 5 is brought into contact with a concave portion of the lower mold 22. This exposes the protective layer 3 to the inside of the mold.

Next, in the method as illustrated in FIG. 3C, the mold material 18 that is the material component of the sealing member 13 is injected in the mold 20. The mold material 18 and the protective layer 3 are in contact and heated, thereby transferring the hard coating layer 14 produced by thermally curing the protective layer 3 to the mold resin (transfer step).

More specifically, in the step, the mold material 18 is first injected into the lower mold 22 on which the transfer material 5 is disposed. Then, the semiconductor chip 11 connected to the substrate 12 is placed on the mold material 18.

Thereafter, the upper mold 21 is put together with the lower mold 22. The upper mold 21 and the lower mold 22 are brought into contact and aligned with the substrate 12. The semiconductor chip 11 is embedded in the mold material 18. Then, the mold material 18 and the semiconductor chip 11 connected to the substrate 12 are sealed in the mold 20. At the same time, the mold 20 is heated (heating process is carried out).

In this manner, the mold material (thermally uncured mold resin) 18 and the thermally uncured protective layer 3 are heated and thermally reacted in their contact situation, thereby chemically bonding them. Meanwhile, the mold material (thermally uncured mold resin) 18 is cured to form the sealing member 13. Further, the thermally uncured protective layer 3 is thermally cured to form the hard coating layer 14.

The heating process in the transfer step may be a single-step reaction or a multi-step reaction.

In a single-step reaction, the molding and thermal reaction are carried out in the mold 20 under the following conditions.

For the thermal reaction conditions, the reaction temperature is, for example, 40°C or more, preferably 60°C or more and, for example, 200°C or less, preferably 150°C or less. Meanwhile, the reaction time is, for example, 1 hour or more, preferably 2 hours or more and, for example, 20 hours or less, preferably 12 hours or less.

This allows the thermally reactive group (protective layer-side thermally reactive group) of the active energy ray-curable resin contained in the protective layer 3 to thermally react with the thermally reactive group (mold-side thermally reactive group) contained in the mold material 18 and connects them by chemical bonding.

Meanwhile, the mold material 18 (thermally uncured mold resin) is thermally cured (fully cured) and the sealing member 13 is produced.

Further, at the same time, the protective layer 3 is thermally cured (internally crosslinked) and a hard coating layer 14 is produced as a thermally cured product of the protective layer 3.

In other words, in the step, the sealing member 13 is produced as a cured product of the mold material 18 and the hard coating layer 14 is produced as a cured product of the active energy ray-curable resin. Further, the hard coating layer 14 is connected to the sealing member 13 by chemical bonding.

Thereafter, in the method as illustrated in FIG. 3D, the hard coating layer 14 is released from the substrate sheet 2 (release step).

Further, as necessary, the excess of the hard coating layer 14 is cut and removed as illustrated with the arrows in FIG. 3D. This provides the semiconductor sealing package 10.

In the semiconductor sealing package 10 produced as described above, the substrate 12, the sealing member 13, and the hard coating layer 14 are sequentially laminated from one side (lower side) toward the other side (upper side). The sealing member 13 has a peripheral surface connecting a surface (lower surface) of the one side to a surface (upper surface) of the other side.

The hard coating layer 14 is disposed on the surface (upper surface) of the other side and peripheral surface of the sealing member 13. In this manner, the sealing member 13 is protected and has excellent durability.

Further, in this producing method of the semiconductor sealing package 10, the transfer material 5 including the above-described multi-layered sheet 1 is used.

Thus, as described above, the mold material (thermally uncured mold resin) 18 and the protective layer 3 are brought into contact and heated, thereby chemically bonding them. Further, the mold material (thermally uncured mold resin) 18 is cured to form the sealing member 13 as a cured product. In addition, the protective layer 3 is cured to form the hard coating layer 14.

This allows the hard coating layer 14 to adhere to the sealing member 13 without providing an adhesive layer.

In the transfer step of this method, the gap between the upper mold 21 and the lower mold 22 caused by the substrate 12 is sometimes crushed by the pressure of the mold 20. This may bring the surface of the protective layer 3 of the transfer material 5 into contact with the lower surface of the upper mold 21 or the jig (described below).

However, the above-described protective layer 3 has a polysiloxane chain. Thus, even when the surface of the protective layer 3 contacts the lower surface of the upper mold 21 or the jig, the adherence thereof is suppressed. Thus, the contamination of the molding tool is suppressed.

That is, in the method of producing the described-above semiconductor sealing package 10, the contamination of the molding tool (mold 20) is suppressed and the semiconductor sealing package 10 with excellently adhesion between the sealing member 13 and the hard coating layer 14 is efficiently produced.

In the produced semiconductor sealing package 10, the contamination of the molding tool (mold 20) is suppressed and the sealing member 13 adheres to the hard coating layer 14 without the mediation of an adhesive layer.

Thus, the multi-layered sheet 1, the transfer material 5, the semiconductor sealing package 10, and the producing method thereof are suitably used in various semiconductor industries.

In the description, the substrate sheet 2 of the multi-layered sheet 1 is formed of, for example, a plastic film. However, for example, to improve the releasability of the protective layer 3 (hard coating layer 14), for example, the substrate sheet 2 can include an easily peelable layer 8.

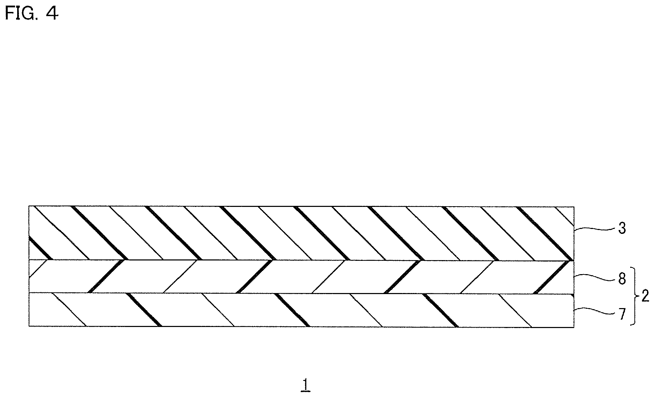

In such a case, as illustrated in FIG. 4, the substrate sheet 2 includes a supporting layer 7, and the easily peelable layer 8 laminated on one surface of the supporting layer 7. Furthermore, the protective layer 3 is laminated on one surface of the easily peelable layer 8.

Examples of the supporting layer 7 include the plastic film described above as the substrate sheet 2.

Examples of the easily peelable layer 8 include a surface layer made of water-repellent resin such as fluorine resin, silicone resin, melamine resin, cellulose derivatives resin, urea resin, polyolefin resin, and paraffin resin.

The substrate sheet 2 including the easily peelable layer 8 facilitates easier release of the protective layer 3 (the hard coating layer 14) from the substrate sheet 2 and improves the production efficiency of the semiconductor sealing package 10.

Although not illustrated, as necessary, the multi-layered sheet 1 and the transfer material 5 can include a functional layer such as a design layer, a shield layer, or an embossed layer in addition to the substrate sheet 2 and the protective layer 3.

In such a case, the functional layer is formed on the other surface of the substrate sheet 2 (opposite to the surface on which the protective layer 3 is formed) or between the substrate sheet 2 and the protective layer 3. This formation exposes the protective layer 3 as the uppermost surface of the multi-layered sheet 1. Preferably, the multi-layered sheet 1 consists of the substrate sheet 2 and the protective layer 3.

In the above-described method, the shape of the mold 20 is not especially limited. For example, the inner space of the concave portion of the mold 20 can be designed as an arbitrary shape such as a lens shape to produce the sealing member 13 having an arbitrary shape.

Alternatively, a design such as concavities and convexities (embossment) can be applied on the surface of a concave portion of the mold 20. Further, as necessary, the shape is formed by reducing the pressure in the mold 20.

Alternatively, depending on the shape of the internal space of the concave portion of the mold 20 or the shape of the surface of the concave portion of the mold 20, the protective layer 3 and the hard coating layer 14 are formed into a lens shape. Alternatively, the surface (the other surface opposite to one surface in contact with the sealing member 13) of the protective layer 3 and the hard coating layer 14 has a concave-convex (embossed) shape. Further, the protective layer 3 and the hard coating layer 14 can partially have a different thickness. In this case, without changing the mold 20, the protective layer 3 and the hard coating layer 14 can develop a variety of other functions in addition to a function for protecting the sealing member 13.

Alternatively, in the above-described method, a concave portion is formed on the lower mold 22 and the lower mold 22 is filled with the mold material 18. However, for example, a concave portion can be formed on the upper mold 21 and the upper mold 21 can be filled with the mold material 18. Both the lower mold 22 and the upper mold 21 can be filled with the mold material 18.

Similarly, in the above-described description, the hard coating layer 14 is formed on the upper surface and the peripheral surfaces of the sealing member 13. However, the hard coating layer 14 may protect at least a part of the surface of the sealing member 13. For example, the hard coating layer 14 is disposed only on the surface of the other side (the upper surface) of the sealing member 13 and is not disposed on the peripheral surfaces of the sealing member 13.

For example, when a photo semiconductor device (such as a light emitting and/or receiving element) is sealed as the semiconductor chip 11, the hard coating layer 14 is not disposed on the peripheral surfaces of the sealing member 13 for better optical properties. In other words, when a photosemiconductor device (such as a light emitting and/or receiving element) is sealed as the semiconductor chip 11, preferably, the hard coating layer 14 is not disposed on the peripheral surfaces of the sealing member 13 but is disposed only on the surface of the other side (the upper surface) of the sealing member 13 (see FIG. 5E described below).

Similarly, in the above-described description, one semiconductor sealing package 10 is formed in one concave portion of the mold 20. However, for example, a plurality of semiconductor sealing packages 10 can be formed in one concave portion of the mold 20.

That is, in the transfer step (see FIG. 3C) of this method, a substrate 12 including a plurality of semiconductor chips 11 is prepared first.

Next, in this method as illustrated in FIG. 5A, a plurality of (three in FIG. 5A) semiconductor chips 11 connected to the substrate 12 is placed on the mold material 18 injected in the mold 20.

Thereafter, the upper mold 21 is put together with the lower mold 22 and the upper mold 21 and the lower mold 22 are brought into contact with the substrate 12 for alignment. Then, the semiconductor chips 11 are embedded in the mold material 18.

Subsequently, the mold material 18 and the semiconductor chips 11 connected to the substrate 12 are sealed in the mold 20 while the mold 20 is heated (subjected to heating process).

In this manner, the mold material (thermally uncured mold resin) 18 and the thermally uncured protective layer 3 are brought into contact and heated for thermal reaction, thereby chemically bonding them each other. Meanwhile, the mold material (thermally uncured mold resin) 18 is cured to form the sealing member 13. Further, the thermally uncured protective layer 3 is thermally cured to form the hard coating layer 14.

The heating process in the transfer step may be a single-step reaction or a multi-step reaction.

To improve the production efficiency, preferably, a multi-step reaction is adopted.

The multi-step reaction is not especially limited as long as the reaction has two or more steps. Preferably, a two-step reaction is used.

More specifically, in the transfer step of this method, as illustrated in FIG. 5A, the mold material (thermally uncured mold resin) 18 and the thermally uncured protective layer 3 are in contact and pre-cured (subjected to the first heating) (a first heating step).

For the heating conditions in the first heating step, the heating temperature is, for example, 40°C or more, preferably 60°C or more and, for example, 200°C or less, preferably 150°C or less. Meanwhile, the heating time is, for example, 1 minute or more, preferably 5 minutes or more and, for example, 30 minutes or less, preferably 15 minutes or less.

By such pre-curing, the half-thermally cured mold resin (hereinafter, sometimes referred to as a "half-cured mold product") 19 chemically bonds to the half-thermally cured protective layer 3.

More specifically, by setting the heating conditions in the first heating step as described above, the mold material 18 and the protective layer 3 are half cured. Meanwhile, the thermal reaction allows a part of the thermally reactive groups (protective layer-side thermally reactive groups) of the active energy ray-curable resin in the protective layer 3 to chemically bond to a part of the thermally reactive groups (mold-side thermally reactive groups) in the mold material 18.

In this manner, by the pre-curing, the thermal reaction chemically bonds a part of the mold-side thermally reactive groups to a part of the protective layer-side thermally reactive groups. This allows the half-cured mold product 19 and the protective layer 3 to provisionally connect to each other at a strength at which the half-cured mold product 19 and the protective layer 3 are not released from each other.

Next, in this method, as illustrated in FIG. 5B, while the half-cured mold product (half-thermally cured mold resin) 19 is taken from the mold 20, the transfer material 5 is released from the half-cured mold product 19 (release step).

After the above-described pre-curing, even when the transfer material 5 is released, the connection between the half-cured mold product 19 and the half-thermally cured protective layer 3 can be maintained. As necessary, the excess of the protective layer 3 can be cut and removed.

Thereafter, in this method, as illustrated in FIG. 5C, the half-cured mold product (half-thermally cured mold resin) 19 and the half-thermally cured protective layer 3 are further heated and post-cured (subjected to a second heating) (a second heating step).

For the heating conditions in the second heating step, the heating temperature is, for example, 40°C or more, preferably 60°C or more and, for example, 200°C or less, preferably 150°C or less. Meanwhile, the heating time is, for example, 30 minutes or more, preferably 2 hours or more and, for example, 20 hours or less, preferably 12 hours or less.

By such post-curing, the sealing member 13 as a thermally cured product of the mold material 18 and the hard coating layer 14 as a thermally cured product of the protective layer 3 are produced and chemically bonded.

More specifically, by setting the heating conditions in the second heating step as described above, the thermal reaction allows the rest of the thermally reactive groups (protective layer-side thermally reactive groups) of the active energy ray-curable resin in the protective layer 3 to chemically bond to the rest of the thermally reactive groups (mold-side thermally reactive groups) in the half-cured mold product 19.

By the post-curing, the thermal reaction of the rest of the mold-side thermally reactive group and the rest of the protective layer-side thermally reactive group is completed. This can completely cure these thermally reactive groups. As a result, the sealing member 13 as a cured product of the mold material 18 can be connected to the hard coating layer 14 as a cured product of the protective layer 3 by chemical bonding.

As described above, the heating process in the transfer step includes two steps, namely, the first heating step (pre-curing (curing during the molding)) and the second heating step (post-curing (curing after the molding)). This shortens the molding time and improves the workability.

That is, in the above-described transfer step, after the mold material 18 is half-cured in the mold 20, the mold material 18 in a state of the half-cured mold product 19 is taken from the mold 20 without being fully cured in the mold 20 (while the molding time is shortened). Separately, the mold material 18 can be fully cured outside the mold 20.

By this method, the turnover (cycle performance) of the mold 20 is improved.

Further, by this method, with good production efficiency, a semiconductor sealing package assembly 25 is formed as a hard coating layer-laminated mold resin assembly including a plurality of semiconductor sealing packages 10 as hard coating layer-laminated mold resin.

Thereafter, in this method, as illustrated in FIG. 5D, the semiconductor sealing package assembly 25 is divided into a plurality of (three in FIG. 5D) semiconductor sealing packages 10 (dicing step).

In the dicing step, without using a dicing tape (not illustrated) the semiconductor sealing package assembly 25 can be fixed in the jig and divided. However, for improving the handling, preferably, a dicing tape (not illustrated) is disposed on the semiconductor sealing package assembly 25 before the division.

At any time before the division in the dicing step, the dicing tape (not illustrated) can be disposed on the semiconductor sealing package assembly 25 after the above-described the transfer step or can be disposed on the semiconductor sealing package assembly 25 before the above-described the transfer step.

For example, when the dicing tape (not illustrated) is disposed after the above-described transfer step, the semiconductor sealing package assembly 25 produced in the transfer step is placed on the dicing tape (not illustrated). In this manner, the dicing tape (not illustrated) is adhered to a back side (opposite to a surface of the side on which the semiconductor chip 11 is disposed) of the substrate 12.

In this case, the adherence of the substrate 12 and the dicing tape (not illustrated) is carried out, for example, after the post-curing step, or after the above-described the pre-curing step and before the post-curing step.

Alternatively, for example, when the dicing tape (not illustrated) is disposed before the above-described transfer step, the substrate 12, where the dicing tape (not illustrated) is adhered to its back side in advance, is used in the transfer step. Then, in the above-described the transfer step, the substrate 12, where the dicing tape (not illustrated) is adhered to its back side in advance, is used to produce the semiconductor sealing package assembly 25.

To prevent the adherence of the dicing tape (not illustrated) to other than the substrate 12 or the deterioration of the dicing tape (not illustrated), preferably, the dicing tape (not illustrated) is disposed on and adhered to the semiconductor sealing package assembly 25 after the transfer step.

Then, in this step, the semiconductor sealing package assembly 25 is divided (diced or singulated) on the dicing tape (not illustrated).

The dicing method is not especially limited. However, for example, dicing methods such as blade dicing, stealth dicing (stealth laser dicing), and laser dicing (other than stealth laser dicing) are adopted.

The dicing conditions are not especially limited and appropriately set in accordance with the purpose and intended use.

The semiconductor sealing package assembly 25 is divided in this manner, thereby producing the semiconductor sealing package 10 as illustrated in FIG. 5E.

Further, in the above-described method, to produce the semiconductor sealing package 10 with excellent optical properties, preferably, blade dicing and/or laser dicing are/is adopted.

That is, when the semiconductor sealing package assembly 25 is divided by blade dicing and/or laser dicing, the peripheral surfaces of the sealing member 13 of the semiconductor sealing package 10 are allowed to be rough. Thus, the optical properties are excellent.

More specifically, when the peripheral surfaces of the sealing member 13 are rough surfaces and a light emitting element or a light receiving element is sealed as the semiconductor chip 11, the incident light from the peripheral surfaces of the sealing member 13 is diffused. Thus, excellent optical properties are obtained.

Further, the above-described hard coating layer 14 has a surface with excellent smoothness. Thus, the upper surface of the semiconductor sealing package 10 has excellent optical properties. Particularly, the semiconductor sealing package 10 is suitable for a sealing package of a light receiving element that, for example, a spot light enters.

That is, the substrate 12, the sealing member 13, and the hard coating layer 14 are sequentially laminated from one side (lower side) toward the other side (upper side). The semiconductor sealing package 10 in form in which the hard coating layer 14 is disposed only on the upper surface of the sealing member 13 and is not disposed on the peripheral surfaces of the sealing member 13 is preferable for the optical properties.

In addition, for the optical properties, the surface roughness of the peripheral surfaces of the sealing member 13 is larger than the surface roughness of the hard coating layer 14.

More specifically, the surface roughness of the hard coating layer 14 (measurement method: a method using a non-contact measuring instrument in accordance with ISO 25178) is, for example, Sa 1 μm or less, preferably Sa 0.5 μm or less.

The surface roughness of the peripheral surfaces of the sealing member 13 (measurement method: a method using a non-contact measuring instrument in accordance with ISO 25178) is, for example, Sa 2 μm or more, preferably Sa 5 μm or more and, for example, Sa 20 μm or less, preferably Sa 10 μm or less.

Preferably, the surface roughness of the sealing member 13 is larger than the surface roughness of the hard coating layer 14. The difference between them is, for example, Sa 0.5 μm or more, preferably Sa 1 μm or more and, for example, Sa 20 μm or less, preferably Sa 10 μm or less.

Further, for the optical properties, the surface roughness of the peripheral surfaces of the hard coating layer 14 is preferably larger than that of the surface of the hard coating layer 14.

More specifically, the surface roughness of the peripheral surfaces of the hard coating layer 14 (measurement method: a method using a non-contact measuring instrument in accordance with ISO 25178) is, for example, Sa 2 μm or more, preferably Sa 5 μm or more and, for example, Sa 20 μm or less, preferably Sa 10 μm or less.

Further, the surface roughness of the peripheral surfaces of the hard coating layer 14 is preferably larger than the surface roughness of the hard coating layer 14. The difference between them is, for example, Sa 0.5 μm or more, preferably Sa 1 μm or more and, for example, Sa 20 μm or less, preferably Sa 10 μm or less.

When the surface roughness of the hard coating layer 14, the surface roughness of the peripheral surfaces of the hard coating layer 14, and the surface roughness of the peripheral surfaces of the sealing member 13 are in the above-described ranges, the semiconductor sealing package 10 with particularly excellent optical properties is produced.

However, each of the surface roughnesses and the differences are not limited to the above-described numerical values.

Further, also in the above-described method, the contamination of the molding tool (the mold 20) is suppressed and the semiconductor sealing package 10 with excellent adhesion between the sealing member 13 and the hard coating layer 14 is efficiently produced.

Further, the semiconductor sealing package 10 is produced while the contamination of the molding tool (the mold 20) is suppressed. Thus, the sealing member 13 is adhered to the hard coating layer 14 without the mediation of an adhesive layer.

Further, in the above-described method, the mold material (thermally uncured mold resin) 18 is brought into contact with the thermally uncured protective layer 3 and is heated, thereby chemically bonding them. However, for example, it is also possible that the half-cured mold product (half-thermally cured mold resin) 19 can be brought into contact with the thermally uncured protective layer 3 and be heated, thereby chemically bonding them.

More specifically, in this method, in the same manner as described above, a transfer material 5 including a multi-layered sheet 1 is prepared first (the transfer material preparation step (see FIG. 3A)).

On the other hand, in this method, as illustrated in FIG. 6A, a mold material 18 is provisionally molded in the mold 20 (provisional molding step).

More specifically, in this method, instead of the transfer material 5, a known peelable sheet 26 is disposed in the mold 20. Subsequently, the mold material (thermally uncured mold resin) 18 is injected in the mold 20. Meanwhile, in the same manner as described above, the upper mold 21 and the lower mold 22 are brought into contact and aligned with the substrate 12. A plurality of semiconductor chips 11 is embedded in the mold material 18. Then, the mold material 18 and the semiconductor chips 11 connected to the substrate 12 are sealed in the mold 20 while the mold 20 is simultaneously heated (pre-cured).

In this manner, the mold material (thermally uncured mold resin) 18 is thermally reacted. The half-cured mold product (half-thermally cured mold resin) 19 is produced (or, molded).

For the heating conditions in the heating molding, the heating temperature is, for example, 40°C or more, preferably 60°C or more and, for example, 200°C or less, preferably 150°C or less. Meanwhile, the heating time is, for example, 1 minute or more, preferably 5 minutes or more and, for example, 30 minutes or less, preferably 15 minutes or less.

Next, in this method, as illustrated in FIG. 6B, the half-cured mold product (half-thermally cured mold resin) 19 is taken from the mold 20. This produces the half-cured mold product (half-thermally cured mold resin) 19 molded in advance (resin preparation step).

Next, in this method, as illustrated in FIG. 6C, the half-cured mold product (half-thermally cured mold resin) 19 is placed on a stage 27 of a known pressing system and the transfer material 5 is disposed thereabove (disposition step).

More specifically, in disposition step, the transfer material 5 is held by a jig not illustrated. Then, the transfer material 5 is disposed above the half-cured mold product 19 so that the protective layer 3 vertically faces the half-cured mold product 19 with a predetermined space therebetween.

Further, as necessary, the transfer material 5 (protective layer 3) is aligned with the half-cured mold product 19 and a vacuum is created around the transfer material 5 (protective layer 3) and the half-cured mold product 19.

Further, a pressing member 28 is disposed above the protective layer 3. Examples of the pressing member 28 is not especially limited and include a known laminator and a press machine.

Next, in this method, as illustrated in FIG. 7D, the pressing member 28 is pressed downwardly to bring the half-cured mold product (half-cured mold resin) 19 into contact with the protective layer 3. Meanwhile, the half-cured mold product 19 and the protective layer 3 are heated to transfer the hard coating layer 14 produced by thermally curing the protective layer 3 to the half-cured mold product 19 (the transfer step).

That is, the half-cured mold product (half-cured mold resin) 19 and the thermally uncured protective layer 3 are in contact and heated for thermal reaction, thereby chemically bonding them. Meanwhile, the thermal curing of the half-cured mold product (half-cured mold resin) 19 is progressed to form the sealing member 13. Further, the thermally uncured protective layer 3 is thermally cured to form the hard coating layer 14.

The heating process in the transfer step may be a single-step reaction or a multi-step reaction. When the heating process is a single-step reaction, the thermal reaction conditions are the same as above described (see FIG. 3).

To improve the production efficiency, preferably, a multi-step reaction is adopted.

The multi-step reaction is not especially limited as long as the reaction has two or more steps. Preferably, a two-step reaction is used.

More specifically, in this method, as illustrated in FIG. 7D, the half-cured mold product (half-cured mold resin) 19 molded in advance and the thermally uncured protective layer 3 are in contact and heated (subjected to the first heating) (a first heating step).

The heating conditions in the first heating step are the conditions under which the half-cured mold product (half-thermally cured mold resin) 19 maintains the half-cured state and can chemically bonds to the protective layer 3.

More specifically, the heating temperature is, for example, 40°C or more, preferably 60°C or more and, for example, 200°C or less, preferably 150°C or less. Meanwhile, the heating time is, for example, 1 minute or more, preferably 5 minutes or more and, for example, 30 minutes or less, preferably 15 minutes or less.

By the first heating, the half-cured mold product (half-thermally cured mold resin) 19 chemically bonds to the half-thermally cured protective layer 3.

More specifically, by setting the heating conditions in the first heating step as described above, the half-thermally cured state of the half-cured mold product (half-thermally cured mold resin) 19 is maintained. At the same time, the thermal reaction allows a part of the thermally reactive groups (protective layer-side thermally reactive groups) of the active energy ray-curable resin in the protective layer 3 to chemically bond to a part of the thermally reactive groups (mold-side thermally reactive groups) in the half-cured mold product 19.

By the first heating, a part of the mold-side thermally reactive group chemically bonds to a part of the protective layer-side thermally reactive groups by the thermal reaction. This allows the half-cured mold product 19 and the protective layer 3 to provisionally connect to each other at a strength at which the half-cured mold product 19 and the protective layer 3 are not peeled from each other.

Next, in this method, as illustrated in FIG. 7E, the pressing member 28 is lifted upwardly to release the transfer material 5 from the half-cured mold product 19 (release step).

At any time after the above-described first heating, even when the transfer material 5 is released, the connection between the half-cured mold product 19 and the half-thermally cured protective layer 3 can be maintained. As necessary, the excess of the protective layer 3 can be cut and removed.

Thereafter, in this method, as illustrated in FIG. 7F, the half-cured mold product (half-thermally cured mold resin) 19 and the half-thermally cured protective layer 3 are further heated and post-cured (subjected to the second heating) (a second heating step).

For the heating conditions in the second heating step, the heating temperature is, for example, 40°C or more, preferably 60°C or more and, for example, 200°C or less, preferably 150°C or less. Meanwhile, the heating time is, for example, 30 minutes or more, preferably 2 hours or more and, for example, 20 hours or less, preferably 12 hours or less.

By the post-curing, the sealing member 13 as a thermally cured product of the mold material 18 and the hard coating layer 14 as a thermally cured product of the protective layer 3 are produced and they chemically bond.

More specifically, by setting the heating conditions in the second heating step as described above, the thermal reaction allows the rest of the thermally reactive group (protective layer-side thermally reactive group) of the active energy ray-curable resin in the protective layer 3 to chemically bond to the rest of the thermally reactive group (mold-side thermally reactive group) in the half-cured mold product 19.

By the post-curing, the thermal reaction of the rest of the mold-side thermally reactive groups and the rest of the protective layer-side thermally reactive groups is completed and these groups are fully cured. As a result, the sealing member 13 as a cured product of the mold material 18 is connected to the hard coating layer 14 as a cured product of the protective layer 3 by the chemical bonding.

As described above, the heating process in the transfer step is not carried out at the time of the pre-curing (curing during the molding). Instead, providing the two steps of the first heating step and the second heating step after the pre-curing of the mold resin (after the molding) shortens the molding time and shortens the first heating time requiring the jig or the like. Thus, the workability is improved.

Thereafter, in this method, as illustrated in FIG. 7G, in the same manner as described above (see FIG. 5D), the semiconductor sealing package assembly 25 is divided into a plurality of semiconductor sealing packages 10 (the dicing step).

In this manner, as illustrated in FIG. 7H, the semiconductor sealing package 10 is produced.

By the above-described method, the contamination of the molding tool (such as a jig) is suppressed and the semiconductor sealing package 10 with excellently adhesion between the sealing member 13 and the hard coating layer 14 is efficiently produced.

Further, the semiconductor sealing package 10 is produced while the contamination of the molding tool (such as a jig) is suppressed. Thus, the sealing member 13 is adhered to the hard coating layer 14 without the mediation of an adhesive layer.

In the above-described embodiment, the protective layer 3 is formed on the entire surface of the substrate sheet 2 in the multi-layered sheet 1 and the transfer material 5. However, for example, the protective layer 3 can be formed only on a part of the surface of the substrate sheet 2.

That is, the protective layer 3 that is the hard coating layer 14 before being thermally cured can be formed only on a part of the surface of the substrate sheet 2 so that the hard coating layer 14 can correspond to the shape of the mold 20 and the shape of the mold resin after the molding (after the pre-curing and before the post-curing).

On the other hand, for the accuracy of the alignment by mechanical feed, the protective layer 3 is formed on a region larger than the mold 20 and the mold resin after being molded.

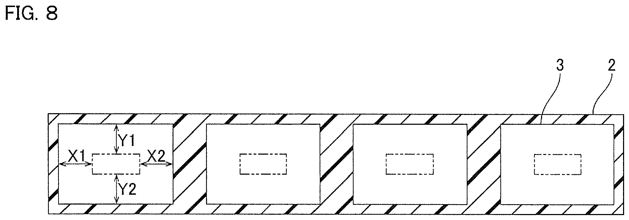

Specifically, for example, when the multi-layered sheet 1 and the transfer material 5 are used in the method illustrated in FIG. 5, FIG. 8 is a plan view (top view) of the substrate sheet 2 and the protective layer 3 when being disposed along the shape of the mold 20 (see FIG. 5B).

In this form, the protective layer 3 is formed into a region (see the white background in FIG. 8) larger than the concave region of the mold 20 in planar view (see the long dashed short double dashed line in FIG. 8).

In such a case, for the accuracy of the alignment by mechanical feed, the size of the region where the protective layer 3 is formed preferably satisfies the following equations (1) and (2).

$$X1 + X2 \geqq 20 \text{ mm } (1)$$

$$Y1 + Y2 \geqq 20 \text{ mm } (2)$$

X1 is the length from an end of one side (left side of the paper sheet) of the concave region of the mold 20 to an end of one side (left side of the paper sheet) of the region where the protective layer 3 is formed in a predetermined first direction (left-right direction of the paper sheet). X2 is the length from an end of the other side (right side of the paper sheet) of the concave region of the mold 20 to an end of the other side (right side of the paper sheet) of the region where the protective layer 3 is formed in the first direction (left-right direction of the paper sheet).

Meanwhile, Y1 is the length from an end of one side (upper side of the paper sheet) of the concave region of the mold 20 to an end of one side (upper side of the paper sheet) of the region where the protective layer 3 is formed in a second direction (upper-lower direction of the paper sheet) orthogonal to the above-described first direction on the plane surface where the mold resin is formed. Y2 is the length from an end of the other side (lower side of the paper sheet) of the concave region of the mold 20 to an end of the other side (lower side of the paper sheet) of the region where the protective layer 3 is formed in the second direction (upper-lower direction of the paper sheet).

Alternatively, when the multi-layered sheet 1 and the transfer material 5 are used in the method illustrated in FIG. 6 and FIG. 7, FIG. 8 is a plan view (top view) of the substrate sheet 2 and the protective layer 3 when being disposed along the shape of the mold resin after being molded (see FIG. 7D).

In this form, the protective layer 3 is formed into a region (see the white background in FIG. 8) larger than the region where the mold resin is formed in planar view (see the long dashed short double dashed line in FIG. 8).

In such a case, for the accuracy of the alignment by mechanical feed, the size of the region where the protective layer 3 is formed preferably satisfies the following equations (1) and (2).

$$X1 + X2 \geqq 20 \text{ mm } (1)$$

$$Y1 + Y2 \geqq 20 \text{ mm } (2)$$

X1 is the length from an end of one side (left side of the paper sheet) of a region where the mold resin is formed to an end of one side (left side of the paper sheet) of the region where the protective layer 3 is formed in a predetermined first direction (left-right direction of the paper sheet). X2 is the length from an end of the other side (right side of the paper sheet) of the region where the mold resin is formed to an end of the other side (right side of the paper sheet) of the region where the protective layer 3 is formed in the first direction (left-right direction of the paper sheet).

Meanwhile, Y1 is the length from an end of one side (upper side of the paper sheet) of the region where the mold resin is formed to an end of one side (upper side of the paper sheet) of the region where the protective layer 3 is formed in a second direction (upper-lower direction of the paper sheet) orthogonal to the above-described first direction on the plane surface where the mold resin is formed. Y2 is the length from an end of the other side (lower side of the paper sheet) of the region where the mold resin is formed to an end of the other side (lower side of the paper sheet) of the region where the protective layer 3 is formed in the second direction (upper-lower direction of the paper sheet).

In any of the cases, preferably, the substrate sheet 2 relatively moves along the first direction (X-axis direction), for example, by mechanical feed. The region where the protective layer 3 is formed faces the mold 20 or the mold resin after being molded.

When the protective layer 3 is formed as described above, the protective layer 3 may contact the mold or the molding tool such as a jig. However, using the above-described multi-layered sheet 1 and transfer material 5 suppresses the contamination of the molding tool.

Further, the above-described semiconductor sealing package 10 includes the semiconductor chip 11 sealed in the sealing member 13. However, depending on the purpose and intended use, the semiconductor sealing package 10 does not include the semiconductor chip 11.

That is, in the description above, the semiconductor sealing package 10 (such as an LED sealing package) is exemplified. However, examples of the hard coating layer-laminated mold resin is not limited to this example. For example, the hard coating layer-laminated mold resin can be used as various hard coating layer-laminated resin articles in various industries such as communication equipment, electrical appliances, housing equipment, and automobiles.

For the use in various industries, preferably, the semiconductor sealing package 10 includes the semiconductor chip 11 sealed in the sealing member 13.

Further, in the semiconductor sealing package 10, various optical components (such as a lens and an optical filter) can be adhered on the surface of the hard coating layer 14.

In such a case, the hard coating layer 14 has high smoothness. Thus, an optical component can accurately be disposed. Therefore, a photo semiconductor device with excellent optical properties can be produced.

In the present invention, the smoothness of the hard coating layer 14 means not only the flat surface but also the smoothness of the surfaces of the lens shape and the concave convex shape.

The above-described pre-curing means a step in which provisional curing is carried out as a processing step before the final curing of the thermally curable rein used for molding. The pre-curing is carried out for curing and forming a stable shape at a degree that a final strength is not provided. The curing at the final strength is referred to as "post-curing" and is generally carried out at a higher temperature and for a longer time than those for the pre-curing.

Examples

Next, the present invention will be described based on Examples and Comparative Examples. However, the present invention is not limited to Examples described below. The "parts" and "%" are based on mass unless otherwise specified. The specific numeral values used in the description below, such as mixing ratios (contents), physical property values, and parameters can be replaced with corresponding mixing ratios (contents), physical property values, parameters in the above-described "DESCRIPTION OF EMBODIMENTS", including the upper limit value (numeral values defined with "or less", and "less than") or the lower limit value (numeral values defined with "or more", and "more than").

1. Measuring Method

<Weight-average molecular weight and Number-average molecular weight>

0.2 mg of a sample was taken from the (meth)acrylic resin. The sample was dissolved in 10 mL of tetrahydrofuran to measure the molecular weight distribution of the sample with gel permeation chromatograph (GPC) equipped with a refractive index detector (RID), thereby obtaining chromatogram (chart).

Subsequently, the weight-average molecular weight and number-average molecular weight of the sample was calculated from the obtained chromatogram (chart) with the standard polystyrene as a calibration curve. The measurement device and the measurement conditions are shown below.

Data processing apparatus: product name HLC-8220GPC (manufactured by TOSOH CORPORATION)
Refractive index detector: RI detector built in product name HLC-8220GPC
Column: three pieces of product name "TSKgel GMHXL" (manufactured by TOSOH CORPORATION)
Mobile phase: tetrahydrofuran
Column flow rate: 0.5 mL/min
Injection amount: 20 μL
Measurement temperature: 40°C
Molecular weight of standard polystyrene: 1250, 3250, 9200, 28500, 68000, 165000, 475000, 950000, 1900000

<Glass transition temperature>

The glass transition temperature of the (meth)acrylic resin was determined by the Fox equation.

<Viscosity>

The viscosity was measured in accordance with JIS K5600-2-3 (2014)

<Acid value>

The acid value was measured in accordance with JIS K5601-2-1 (1999)

<Concentration of non-volatile content>

The concentration of the non-volatile content was measured in accordance with JIS K5601-2-1 (2008)

<Epoxy equivalent>

The epoxy equivalent was measured in accordance with JIS K7236 (2001)

<Hydroxyl value>

The hydroxyl value of the (meth)acrylic resin was measured in accordance with JIS K1557-1:2007 (ISO 14900: 2001) 4.2B of "Plastics-Polyols for use in the production of polyurethane-Part 1: Determination of hydroxyl number"

The hydroxyl value of the (meth)acrylic resin is the hydroxyl value of the solid content.

<(meth)acryloyl equivalent>

The (meth)acryloyl equivalent of the (meth)acrylic resin was calculated from the monomer composition that is the material for the (meth)acrylic resin in accordance with the following formulation (I).

[Chem 1]

$$(\text{Meth})\text{acryloyl}\ (\text{g/eq})\ = W/\sum_{i=1}^{k}(M_i \times N_i) \qquad (\text{I})$$

In the formulation (I), "W" is the total usage (g) of the monomers used as the material for the (meth)acrylic resin, "M" is the molarity (mol) of the monomers arbitrarily selected from the monomers used for introducing the (meth)acryloyl group as a side chain to the main chain of the (meth)acrylic resin finally produced in the synthesis of the (meth)acrylic resin, "N" is the number of the (meth)acryloyl groups per one molecule of the arbitrarily selected monomers, and "k" is the number of monomer species used for introducing the (meth)acryloyl group as a side chain to the main chain of the (meth)acrylic resin finally produced in the synthesis of the (meth)acrylic resin.

2. Synthesis of intermediate polymer and active energy ray-curable resin

Synthesis Examples 1 to 14

A reaction vessel was charged with 400 parts by weight of methyl isobutyl ketone (MIBK) as a solvent. The mixture was heated to 90 °C and the temperature was maintained.

Glycidyl methacrylate (thermally reactive group-containing compound, GMA), acrylic acid (thermally reactive group-containing compound, AA), 2-hydroxyethyl acrylate (thermally reactive group-containing compound, 2-HEA), FM-0721 (polysiloxane-containing compound, trade name, manufactured by JNC, 3-methacryloxypropyldimethylpolysiloxane), methyl methacrylate (another polymerizable compound, MMA), butyl acrylate (another polymerizable compound, BA), and Azobis-2-methylbutyronitrile (ABN-E) as a radical polymerization initiator were mixed in the amounts shown in Tables 1 to 4, thereby obtaining the polymerizable component.

Subsequently, the polymerizable component was gradually dropped and mixed in the reaction vessel for two hours and was left for two hours. Then, the mixture was heated at 110 °C for two hours for radical polymerization.

In this manner, an intermediate polymer solution was obtained. The intermediate polymer solution was cooled to 60 °C.

The glass transition temperature of the obtained intermediate polymer was measured by the above-described method.

Subsequently, with the intermediate polymer solution, acrylic acid (active energy ray-curable group-containing compound, AA), glycidyl methacrylate (active energy ray-curable group-containing compound, GMA), 2-isocyanatoethyl acrylate (active energy ray-curable group-containing compound, AOI), p-methoxyphenol (polymerization inhibitor, MQ), triphenylphosphine (catalyst, TPP), and dibutyltindilaurate (catalyst, DBTDL) were mixed in the amounts shown in Table 1 to 4.

Subsequently, while oxygen was sent in the reaction vessel, the mixture was heated at 110 °C for 8 hours. To the thermally reactive group of the intermediate polymer, acrylic acid (active energy ray-curable group-containing compound, AA), glycidyl methacrylate (active energy ray-curable group-containing compound, GMA), and/or 2-isocyanatoethyl acrylate (active energy ray-curable group-containing compound, AOI) were/was added.

More specifically, a part of the epoxy groups of the intermediate polymer was reacted with the carboxy groups of acryl acid to add an acryloyl group as the active energy ray-curable group to the side chain.

At the same time, the rest of the epoxy groups and the hydroxyl group generated by the ring opening of the epoxy group were kept unreacted (free) as a thermally reactive group.

Meanwhile, a part of the carboxy groups of the intermediate polymer was reacted with the epoxy groups of glycidyl methacrylate to add a methacryloyl group as the active energy ray-curable group to the side chain. At the same time, the rest of the carboxy groups and the hydroxyl group generated by the ring opening of the epoxy group were kept unreacted (free) as a thermally reactive group.

Meanwhile, a part of the hydroxyl groups of the intermediate polymer was reacted with the isocyanate groups of 2-isocyanatoethyl acrylate to add an acryloyl group as the active energy ray-curable group to the side chain. At the same time, the rest of the hydroxyl group was kept unreacted (free) as a thermally reactive group.

In this manner, the (meth)acrylic resin was obtained as the active energy ray-curable resin. As necessary, the solvent was added or removed, thereby adjusting the non-volatile content concentration of the active energy ray-curable resin to 30 mass%.

The hydroxyl value, (meth)acryl equivalent, and weight-average molecular weight of the obtained active energy ray-curable resin were measured. The amounts of the thermally reactive groups (remaining thermally reactive group), polysiloxane chains, and active energy ray-curable groups remaining in 1 g of the active energy ray-curable resin were calculated from the charged ratio. The results are shown in Tables 1 to 4.

3. Multi-layered sheet and hard coating layer-laminated mold resin

Examples 1 to 13 and Comparative Examples 1 to 2

Multi-layered sheet

Each of the (meth)acrylic resin shown in Tables 5 to 8 was applied on one surface of a substrate sheet (manufactured by Oji F-Tex Co. Ltd., an olefin film having a thickness of 50 $\mu$m) with a bar coater and heated at 60 °C for one minute to remove the solvent.

Thereafter, the (meth)acrylic resin was cured by UV irradiation, thereby forming a protective layer having a thickness of 1 $\mu$m.

In this manner, a multi-layered sheet including a substrate sheet and a protective layer was produced.

In Examples 1 to 12, ultraviolet (UV) light with the dominant wavelength of 365 nm was delivered using a high pressure mercury lamp so that the accumulated light volume was 500 mJ/cm$^2$. The UV irradiation allowed all the acryloyl groups of the (meth)acrylic resin to react, thereby providing a protective layer as a fully-cured product.

On the other hand, in Example 13, ultraviolet (UV) light with the dominant wavelength of 365 nm was delivered using a high pressure mercury lamp so that the accumulated light volume was 200 mJ/cm$^2$. The UV irradiation allowed a part of the acryloyl groups of the (meth)acrylic resin to react, thereby providing a protective layer as a half-cured product. The rest of the acryloyl groups was kept unreacted.

· Hard coating layer-laminated mold resin

A casting mold formed of a set of an upper mold and a lower mold was prepared. The multi-layered sheet was set on the lower mold so that the protective layer faces the inside of the mold. For making accurate evaluations in accordance with JIS K 5600-5-6 (1999) of the tight contact of the hard coating layer-laminated mold resin formed by the mold, a mold having a flat and smooth surface was used as the lower mold.

Thereafter, an epoxy resin composition (manufactured by Marumoto Struers K.K. epoxy resin trade name EPOFIX) as the mold material was injected and filled in the mold. The upper mold was set thereon. And curing was carried out at 100°C for one hour. In this manner, the mold resin (epoxy resin molded article) was produced while the mold resin was connected to the protective layer of the multi-layered sheet by thermal curing reaction.

In Example 13, the heating allowed the remaining acryloyl groups to be self-crosslinked, thereby further curing the protective layer.

Thereafter, the mold resin (molded article) was removed from the mold. At the same time, the substrate sheet was peeled from the hard coating layer, thereby producing the hard coating layer-laminated mold resin.

Comparative Example 3

The (meth)acrylic resin of Table 8 was applied to one surface of the substrate sheet (manufactured by Oji F-Tex Co. Ltd., an olefin film having a thickness of 50 $\mu$m) with a bar coater and heated at 60 °C for one minute to remove the solvent.

Thereafter, the (meth)acrylic resin was cured by UV irradiation, thereby forming a protective layer having a film thickness of 1 $\mu$m.

Thereafter, HARIACRON 350B (trade name, acryl pressure sensitive adhesive composition, manufactured by Harima Chemicals Group, Inc.) was applied to one surface of the protective layer with a bar coater and heated at 60 °C for one minute, thereby forming an adhesive layer having a film thickness of 1 $\mu$m.

In this manner, a multi-layered sheet including the substrate sheet, the protective layer, and the adhesive layer was produced.

In the same manner as Example 1, a hard coating layer-laminated mold resin was produced.

Comparative Example 4

To evaluate the properties of the mold resin, the mold resin was laminated on a substrate sheet. That is, an epoxy resin composition (manufactured by Marumoto Struers K.K. epoxy resin trade name EPOFIX) was applied as the mold material on one surface of the substrate sheet (manufactured by Oji F-Tex Co. Ltd., an olefin film having a thickness of 50 $\mu$m) with a bar coater. Then, the solvent was removed by drying.

In this manner, a mold material layer (thermally uncured epoxy resin layer) having a film thickness of 1 $\mu$m was formed on the substrate sheet, thereby producing a multi-layered sheet.

Subsequently, a casting mold formed of a set of an upper mold and a lower mold was prepared. The multi-layered sheet was set on the lower mold so that the protective layer faces the inside of the mold. For making accurate evaluations in accordance with JIS K 5600-5-6 (1999) of the tight contact of the laminated mold resin formed by the mold, a mold having a flat and smooth surface was used as the lower mold.

Thereafter, an epoxy resin composition (manufactured by Marumoto Struers K.K. epoxy resin trade name EPOFIX) was injected and filled as the mold material in the mold. The upper mold was set thereon. And curing was carried out at 100°C for one hour.

In this manner, the mold resin (epoxy resin molded article) was produced. At the same time, the mold resin layer (thermally cured epoxy resin layer) was formed by the thermal curing of the mold material layer. In this manner, the mold resin as a molded resin was connected to the mold resin layer (thermally cured epoxy resin layer) of the multi-layered sheet by the thermal curing reaction.

Thereafter, the mold resin (molded article) was removed from the mold while the substrate sheet was peeled from the surface layer (thermally cured layer), thereby producing the mold resin with the surface layer (thermally cured layer).

4. Evaluations

(1) Tensile elongation

The tensile elongation of the multi-layered sheet was measured in accordance with Plastics-Determination of tensile properties (JIS K7127 (1999)).

Specifically, using a test piece having a thickness of 30 $\mu$m, a width of 25 mm, and a length of 115 mm, the tensile elongation (%) until the test piece was broken was measured under the conditions of a tensile speed 100 mm/minute, a distance between the chucks of 80 mm, a gauge distance of 25 mm, and a temperature of 23°C.

The evaluation standard will be described below.

A: the tensile elongation 10% or more
B: the tensile elongation 5% or more and less than 10%
C: the tensile elongation less than 5%

(2) Pencil hardness

The pencil hardness of the hard coating layer was evaluated in accordance with the testing method of JIS K5600-5-4 (1999) "Scratch hardness (Pencil method)". In Comparative Example 4, the pencil hardness of the mold resin layer (thermally cured epoxy resin layer) was evaluated instead of the hard coating layer.

The evaluation standard was B, HB, F, and H in ascending order of hardness. The larger the number followed by "H" is, the higher the hardness is. The larger the number followed by "B" is, the lower the hardness is.

(3) Tight contact (adhesion)

The tight contact of the hard coating layer with the mold resin was evaluated in accordance with the testing method "Cross-cut test" of JIS K5600-5-6 (1999).

Specifically, the hard coating layer formed on the surface of the described-above hard coating layer-laminated mold resin was vertically and horizontally cut into 100 cut pieces with a cutter knife so that the cross-cuts penetrated to the mold resin.

A pressure sensitive adhesive tape (manufactured by NICHIBAN "Nichiban tape No. 1" was applied on the cross-cuts. The applied tape was removed. Thereafter, the number of the remaining cross-cuts without being peeled off was counted.

In Comparative Example 4, the tight contact of the mold resin layer (thermally cured epoxy resin layer) with the mold resin (molded resin) was evaluated.

(4) Abrasion-resistance

In place of the hard coating layer-laminated mold resin, a test plate with the hard coating layer was prepared.

That is, the (meth)acrylic resin was applied on the surface of the test plate (acryl plate) and photo-cured under the conditions of Examples and Comparative Examples 1 to 3. Thereafter, thermal curing was carried out under the same conditions as those for forming the mold resin. In this manner, a hard coating layer was formed.

For the evaluations of Comparative Example 4, the mold material (epoxy resin composition) was applied on the surface of the test plate (acryl plate). And thermal curing was carried out. In this manner, the mold resin layer (thermally cured epoxy resin layer) was formed on the surface of the test plate (acryl plate).

Thereafter, steel wool (sold by BONSTAR SALES Co., Ltd. product number #0000) horizontally reciprocated 10 times on the surface of the hard coating layer and mold resin layer. The load was 100 g per 1 cm$^2$.

Thereafter, the haze (turbidity) of the hard coating layer and mold resin layer was measured with a haze meter NDH 500 (manufactured by Nippon Denshoku Industries Co., Ltd.) before and after the friction of the steel wool, thereby calculating the color difference ΔE.

The evaluation criteria will be described below.

A: ΔE was 0 or more or less than 1
B: ΔE was 1 or more or less than 3
C: ΔE was 3 or more or less than 10

(5) Mold Contamination

When the hard coating layer-laminated mold resin was formed, the transfer of the hard coating layer at the portion where the hard coating layer in contact with the upper mold was observed and evaluated.

In Comparative Example 4, in the same manner as described above, the transfer of the mold resin layer (thermally cured epoxy resin layer) was observed and evaluated.

The evaluation criteria will be described below. Hereinafter, the hard coating layer or the mold resin layer (thermally cured epoxy resin layer) is the "uppermost layer".

A: The uppermost layer in contact with the upper mold was not transferred to the upper mold at all (transferred area ratio 0%)
B: More than 0% and 10% or less of the area of the coating in the uppermost layer in contact with the upper mold was transferred to the upper mold.
C: More than 10% of the area of the coating in the uppermost layer in contact with the upper mold was transferred to the upper mold.

Table 1

| No. | | | Synthesis Example 1 | Synthesis Example 2 | Synthesis Example 3 | Synthesis Example 4 |
|---|---|---|---|---|---|---|
| Intermediate polymer | | | A-1 | | | |
| Formulation (part(s) by mass) | Thermally reactive group-containing compound | GMA | 70 | | | |
| | | AA | - | | | |
| | | 2-HEA | - | | | |
| | Polysiloxane-containing compound | FM-0721 | 5 | | | |
| | Other polymerizable compounds | MMA | 10 | | | |
| | | BA | 15 | | | |
| | Monomers in total | | 100 | | | |
| | Catalyst | ABN-E | 2 | | | |
| | Solvent | MIBK | 233 | | | |
| Evaluation | Mw (Weight-average molecular weight) | | 20000 | | | |
| | Mn (Number-average molecular weight) | | 10000 | | | |
| | Tg (Glass transition temperature) | | 26°C | | | |
| | Viscosity (mPa·s/25°C) | | 22 | | | |
| | Acid value（mgKOH/g) | | 0.1 | | | |
| | Non-volatile content (mass%) | | 30% | | | |
| | Hydroxyl value（mgKOH/g) | | - | | | |
| | Epoxy equivalent (g/eq) | | 680 | | | |
| Active energy ray-curable resin | | | B-1 | B-2 | B-3 | B-4 |
| Formulation (part(s) by mass) | Intermediate polymer | Type | A-1 | A-1 | A-1 | A-1 |
| | | Solution amount（30%) | 76 | 80 | 85 | 90 |
| | Active energy ray-curable group-containing compound | AA | 7 | 6 | 5 | 3 |
| | | GMA | - | - | - | - |
| | | Karenz AOI | - | - | - | - |
| | Solvent | MIBK | 17 | 14 | 10 | 7 |
| | Total | | 100 | 100 | 100 | 100 |
| | Catalyst | Triphenylphosphine | 0.1 | 0.1 | 0.1 | 0.1 |
| | | Dibutyltin dilaurate | - | - | - | - |
| | Polymerization inhibitor | p-Methoxyphenol | 0.05 | 0.05 | 0.05 | 0.05 |
| Ratio of polysiloxane-containing compound relative to total amount of material (non-volatile content) of active energy ray-curable resin (mass%) | | | 3.8 | 4.0 | 4.3 | 4.5 |
| Thermal reactive group (moles) in active energy ray-curable group-containing compound relative to 100 moles of thermal reactive group in intermediate polymer | | | 90 | 70 | 50 | 30 |
| Number of functional groups (mmol/g) per 1 g of active energy ray-curable resin | Remaining thermally reactive group | | 0.51 | 1.17 | 1.88 | 3.05 |
| | Polysiloxane chain | | 0.0076 | 0.0080 | 0.0085 | 0.0090 |
| | Active energy ray-curable group | | 3.24 | 2.78 | 2.31 | 1.39 |
| Evaluation | Mw (Weight-average molecular weight) | | 21000 | 22000 | 22000 | 21000 |
| | Mn (Number-average molecular weight) | | 12000 | 12000 | 12000 | 11000 |
| | Viscosity (mPa·s/25°C) | | 18 | 17 | 17 | 20 |
| | Non-volatile content (mass%) | | 30% | 30% | 30% | 30% |
| | Acid value（mgKOH/g) | | 0.6 | 0.5 | 0.4 | 0.6 |
| | Hydroxyl value（mgKOH/g) | | 60 | 45 | 35 | 20 |
| | Epoxy equivalent (g/eq) | | 8500 | 3500 | 2200 | 1100 |
| | (Meth)acryloyl equivalent (g/eq) | | 300 | 360 | 480 | 750 |

Table 2

| No. | | | Synthesis Example 5 | Synthesis Example 6 | Synthesis Example 7 | Synthesis Example 8 |
|---|---|---|---|---|---|---|
| Intermediate polymer | | | A-2 | A-3 | A-4 | A-5 |
| Formulation (part(s) by mass) | Thermally reactive group-containing compound | GMA | 50 | 50 | 70 | 70 |
| | | AA | - | - | - | - |
| | | 2-HEA | - | - | - | - |
| | Polysiloxane-containing compound | FM-0721 | 5 | 5 | 5 | 5 |
| | Other polymerizable compounds | MMA | 44 | 10 | 10 | 10 |
| | | BA | 1 | 35 | 15 | 15 |
| | Monomers in total | | 100 | 100 | 100 | 100 |
| | Catalyst | ABN-E | 2 | 2 | 0.5 | 4 |
| | Solvent | MIBK | 233 | 233 | 233 | 233 |
| Evaluation | | Mw (Weight-average molecular weight) | 18000 | 22000 | 80000 | 6000 |
| | | Mn (Number-average molecular weight) | 9500 | 9500 | 34000 | 3500 |
| | | Tg (Glass transition temperature) | 63℃ | 2℃ | 26℃ | 26℃ |
| | | Viscosity (mPa·s/25℃) | 20 | 23 | 450 | 8 |
| | | Acid value（mgKOH/g） | 0.2 | 0.1 | 0.2 | 0.2 |
| | | Non-volatile content (mass%) | 30% | 30% | 30% | 30% |
| | | Hydroxyl value（mgKOH/g） | - | - | - | - |
| | | Epoxy equivalent (g/eq) | 880 | 880 | 680 | 680 |
| Active energy ray-curable resin | | | B-5 | B-6 | B-7 | B-8 |
| Formulation (part(s) by mass) | Intermediate polymer | Type | A-2 | A-3 | A-4 | A-5 |
| | | Solution amount（30%） | 86 | 86 | 85 | 85 |
| | Active energy ray-curable group-containing compound | AA | 3 | 3 | 5 | 5 |
| | | GMA | - | - | - | - |
| | | Karenz AOI | - | - | - | 0 |
| | Solvent | MIBK | 11 | 11 | 10 | 10 |
| | Total | | 100 | 100 | 100 | 100 |
| | Catalyst | Triphenylphosphine | 0.1 | 0.1 | 0.1 | 0.1 |
| | | Dibutyltin dilaurate | - | - | - | - |
| | Polymerization inhibitor | p-Methoxyphenol | 0.05 | 0.05 | 0.05 | 0.05 |
| Ratio of polysiloxane-containing compound relative to total amount of material (non-volatile content) of active energy ray-curable resin (mass%) | | | 4.3 | 4.3 | 4.25 | 4.25 |
| Thermal reactive group (moles) in active energy ray-curable group-containing compound relative to 100 moles of thermal reactive group in intermediate polymer | | | 50 | 50 | 50 | 50 |
| Number of functional groups (mmol/g) per 1 g of active energy ray-curable resin | | Remaining thermally reactive group | 1.64 | 1.64 | 1.88 | 1.88 |
| | | Polysiloxane chain | 0.0086 | 0.0086 | 0.0085 | 0.0085 |
| | | Active energy ray-curable group | 1.39 | 1.39 | 2.31 | 2.31 |
| Evaluation | | Mw (Weight-average molecular weight) | 20000 | 20000 | 85000 | 7000 |
| | | Mn (Number-average molecular weight) | 10000 | 11000 | 38000 | 4000 |
| | | Viscosity (mPa·s/25℃) | 18 | 20 | 550 | 12 |
| | | Non-volatile content (mass%) | 30% | 30% | 30% | 30% |
| | | Acid value（mgKOH/g） | 0.5 | 0.4 | 0.6 | 0.5 |
| | | Hydroxyl value（mgKOH/g） | 20 | 20 | 35 | 35 |
| | | Epoxy equivalent (g/eq) | 1300 | 1300 | 2200 | 2200 |
| | | (Meth)acryloyl equivalent (g/eq) | 640 | 640 | 480 | 480 |

30

Table 3

| No. | | | Synthesis Example 9 | Synthesis Example 10 | Synthesis Example 11 | Synthesis Example 12 |
|---|---|---|---|---|---|---|
| Intermediate polymer | | | A-6 | A-7 | A-8 | A-9 |
| Formulation (part(s) by mass) | Thermally reactive group-containing compound | GMA | 70 | 70 | - | - |
| | | AA | - | - | 50 | - |
| | | 2-HEA | - | - | - | 30 |
| | Polysiloxane-containing compound | FM-0721 | 10 | 0.1 | 5 | 5 |
| | Other polymerizable compounds | MMA | 10 | 10 | 15 | 50 |
| | | BA | 10 | 19.9 | 30 | 15 |
| | Monomers in total | | 100 | 100 | 100 | 100 |
| | Catalyst | ABN-E | 2 | 2 | 2 | 2 |
| | Solvent | MIBK | 233 | 233 | 233 | 233 |
| Evaluation | | Mw (Weight-average molecular weight) | 19000 | 23000 | 26000 | 24000 |
| | | Mn (Number-average molecular weight) | 11000 | 8500 | 9000 | 8000 |
| | | Tg (Glass transition temperature) | 29°C | 22°C | 32°C | 25°C |
| | | Viscosity (mPa·s/25°C) | 21 | 24 | 23 | 18 |
| | | Acid value (mgKOH/g) | 0.1 | 0.1 | 120 | 0.1 |
| | | Non-volatile content (mass%) | 30% | 30% | 30% | 30% |
| | | Hydroxyl value (mgKOH/g) | - | - | - | 44 |
| | | Epoxy equivalent (g/eq) | 680 | 680 | - | - |
| Active energy ray-curable resin | | | B-9 | B-10 | B-11 | B-12 |
| Formulation (part(s) by mass) | Intermediate polymer | Type | A-6 | A-7 | A-8 | A-9 |
| | | Solution amount (30%) | 85 | 85 | 67 | 85 |
| | Active energy ray-curable group-containing compound | AA | 5 | 5 | - | - |
| | | GMA | - | - | 10 | - |
| | | Karenz AOI | - | - | - | 5 |
| | Solvent | MIBK | 10 | 10 | 23 | 10 |
| | Total | | 100 | 100 | 100 | 100 |
| | Catalyst | Triphenylphosphine | 0.1 | 0.1 | 0.1 | - |
| | | Dibutyltin dilaurate | - | - | - | 0.1 |
| | Polymerization inhibitor | p-Methoxyphenol | 0.05 | 0.05 | 0.05 | 0.05 |
| Ratio of polysiloxane-containing compound relative to total amount of material (non-volatile content) of active energy ray-curable resin (mass%) | | | 8.5 | 0.085 | 3.35 | 4.25 |
| Thermal reactive group (moles) in active energy ray-curable group-containing compound relative to 100 moles of thermal reactive group in intermediate polymer | | | 50 | 50 | 50 | 50 |
| Number of functional groups (mmol/g) per 1 g of active energy ray-curable resin | Remaining thermally reactive group | | 1.88 | 1.88 | 2.31 | 1.02 |
| | Polysiloxane chain | | 0.017 | 0.00017 | 0.0067 | 0.0085 |
| | Active energy ray-curable group | | 2.31 | 2.31 | 2.35 | 1.18 |
| Evaluation | | Mw (Weight-average molecular weight) | 21000 | 22000 | 17000 | 26000 |
| | | Mn (Number-average molecular weight) | 12000 | 11000 | 9000 | 11000 |
| | | Viscosity (mPa·s/25°C) | 19 | 18 | 20 | 21 |
| | | Non-volatile content (mass%) | 30% | 30% | 30% | 30% |
| | | Acid value (mgKOH/g) | 0.5 | 0.5 | 60 | 0.2 |
| | | Hydroxyl value (mgKOH/g) | 35 | 35 | 35 | 20 |
| | | Epoxy equivalent (g/eq) | 2200 | 2200 | - | - |
| | | (Meth)acryloyl equivalent (g/eq) | 480 | 480 | 430 | 900 |

Table 4

| No. | | | Synthesis Example 13 | Synthesis Example 14 |
|---|---|---|---|---|
| Intermediate polymer | | | A-10 | A-11 |
| Formulation (part(s) by mass) | Thermally reactive group-containing compound | GMA | 70 | - |
| | | AA | - | - |
| | | 2-HEA | - | - |
| | Polysiloxane-containing compound | FM-0721 | - | 5 |
| | Other polymerizable compounds | MMA | 10 | 65 |
| | | BA | 20 | 30 |
| | Monomers in total | | 100 | 100 |
| | Catalyst | ABN-E | 2 | 2 |
| | Solvent | MIBK | 233 | 233 |
| Evaluation | | Mw (Weight-average molecular weight) | 19000 | 23000 |
| | | Mn (Number-average molecular weight) | 9000 | 11000 |
| | | Tg (Glass transition temperature) | 20°C | 33°C |
| | | Viscosity (mPa·s/25°C) | 21 | 25 |
| | | Acid value (mgKOH/g) | 0.1 | 0.1 |
| | | Non-volatile content (mass%) | 30% | 30% |
| | | Hydroxyl value (mgKOH/g) | - | - |
| | | Epoxy equivalent (g/eq) | 680 | - |
| Active energy ray-curable resin | | | B-13 | B-14 |
| Formulation (part(s) by mass) | Intermediate polymer | Type | A-10 | A-11 |
| | | Solution amount (30%) | 85 | 100 |
| | Active energy ray-curable group-containing compound | AA | 5 | - |
| | | GMA | - | - |
| | | Karenz AOI | - | - |
| | Solvent | MIBK | 10 | - |
| | Total | | 100 | 100 |
| | Catalyst | Triphenylphosphine | 0.1 | - |
| | | Dibutyltin dilaurate | - | - |
| | Polymerization inhibitor | p-Methoxyphenol | 0.05 | - |
| Ratio of polysiloxane-containing compound relative to total amount of material (non-volatile content) of active energy ray-curable resin (mass%) | | | - | - |
| Thermal reactive group (moles) in active energy ray-curable group-containing compound relative to 100 moles of thermal reactive group in intermediate polymer | | | 50 | - |
| Number of functional groups (mmol/g) per 1 g of active energy ray-curable resin | | Remaining thermally reactive group | 1.88 | - |
| | | Polysiloxane chain | 0 | - |
| | | Active energy ray-curable group | 2.31 | - |
| Evaluation | | Mw (Weight-average molecular weight) | 22000 | 23000 |
| | | Mn (Number-average molecular weight) | 8000 | 11000 |
| | | Viscosity (mPa·s/25°C) | 20 | 25 |
| | | Non-volatile content (mass%) | 30% | 30% |
| | | Acid value (mgKOH/g) | 0.5 | 0.1 |
| | | Hydroxyl value (mgKOH/g) | 35 | - |
| | | Epoxy equivalent (g/eq) | 2200 | - |
| | | (Meth)acryloyl equivalent (g/eq) | 480 | - |

Table 5

| No. | | | Example 1 | Example 2 | Example 3 | Example 4 |
|---|---|---|---|---|---|---|
| Multi-layered sheet·Protective layer-laminated mold resin | | | C-1 | C-2 | C-3 | C-4 |
| Formulation (part(s) by mass) | Active energy ray-curable resin | Type | B-1 | B-2 | B-3 | B-4 |
| | | Solid content | 100 | 100 | 100 | 100 |
| | Polymerization initiator | IRGACURE 127 | 0.8 | 0.8 | 0.8 | 0.8 |
| | Total | | 100.8 | 100.8 | 100.8 | 100.8 |
| Polysiloxane group | | | Present | Present | Present | Present |
| Thermally reactive group | | Hydroxyl group | Present | Present | Present | Present |
| | | Epoxy group (glycidyl group) | Present | Present | Present | Present |
| | | Carboxy group | — | — | — | — |
| | | (Meth)acryloyl group | — | — | — | — |
| Adhesive layer | | | Absent | Absent | Absent | Absent |
| Accumulated light volume of radiation (ML/cm$^2$) | | | 500 | 500 | 500 | 500 |
| Evaluation | | Tensile elongation (%) | B | B | A | A |
| | | Pencil hardness | H | H | H | H |
| | | Tight contact | 100/100 | 100/100 | 100/100 | 100/100 |
| | | Abrasion-resistance (ΔE) | A | A | A | B |
| | | Mold contamination (transfer) | A | A | A | A |

Table 6

| No. | | | Example 5 | Example 6 | Example 7 | Example 8 |
|---|---|---|---|---|---|---|
| Multi-layered sheet·Protective layer-laminated mold resin | | | C-5 | C-6 | C-7 | C-8 |
| Formulation (part(s) by mass) | Active energy ray-curable resin | Type | B-5 | B-6 | B-7 | B-8 |
| | | Solid content | 100 | 100 | 100 | 100 |
| | Polymerization initiator | IRGACURE 127 | 0.8 | 0.8 | 0.8 | 0.8 |
| | Total | | 100.8 | 100.8 | 100.8 | 100.8 |
| Polysiloxane group | | | Present | Present | Present | Present |
| Thermally reactive group | | Hydroxyl group | Present | Present | Present | Present |
| | | Epoxy group (glycidyl group) | Present | Present | Present | Present |
| | | Carboxy group | — | — | — | — |
| | | (Meth)acryloyl group | — | — | — | — |
| Adhesive layer | | | Absent | Absent | Absent | Absent |
| Accumulated light volume of radiation (ML/cm$^2$) | | | 500 | 500 | 500 | 500 |
| Evaluation | | Tensile elongation (%) | B | A | B | A |
| | | Pencil hardness | H | H | H | H |
| | | Tight contact | 100/100 | 100/100 | 100/100 | 100/100 |
| | | Abrasion-resistance (ΔE) | A | B | A | B |
| | | Mold contamination (transfer) | A | A | A | A |

Table 7

| No. | | | Example 9 | Example 10 | Example 11 | Example 12 | Example 13 |
|---|---|---|---|---|---|---|---|
| Multi-layered sheet·Protective layer-laminated mold resin | | | C-9 | C-10 | C-11 | C-12 | C-13 |
| Formulation (part(s) by mass) | Active energy ray-curable resin | Type | B-9 | B-10 | B-11 | B-12 | |
| | | Solid content | 100 | 100 | 100 | 100 | 100 |
| | Polymerization initiator | IRGACURE 127 | 0.8 | 0.8 | 0.8 | 0.8 | 0.8 |
| | Total | | 100.8 | 100.8 | 100.8 | 100.8 | 100.8 |
| Polysiloxane group | | | Present | Present | Present | Present | Present |
| Thermally reactive group | | Hydroxyl group | Present | Present | Present | Present | Present |
| | | Epoxy group (glycidyl group) | Present | Present | — | — | — |
| | | Carboxy group | — | — | Present | — | — |
| | | (Meth)acryloyl group | — | — | — | — | Present |
| Adhesive layer | | | Absent | Absent | Absent | Absent | Absent |
| Accumulated light volume of radiation (ML/cm$^2$) | | | 500 | 500 | 500 | 500 | 200 |
| Evaluation | | Tensile elongation (%) | A | A | A | A | A |
| | | Pencil hardness | H | H | H | H | H |
| | | Tight contact | 100/100 | 100/100 | 100/100 | 100/100 | 100/100 |
| | | Abrasion-resistance (ΔE) | A | A | A | B | B |
| | | Mold contamination (transfer) | A | A | A | A | A |

Table 8

| No. | | | Comparative Example 1 | Comparative Example 2 | Comparative Example 3 | Comparative Example 4 |
|---|---|---|---|---|---|---|
| Multi-layered sheet·Protective layer-laminated mold resin | | | C-14 | C-15 | C-16 | C-17 |
| Formulation (part(s) by mass) | Active energy ray-curable resin | Type | B-13 | B-14 | B-1 | — |
| | | Solid content | 100 | 100 | 100 | — |
| | Polymerization initiator | IRGACURE 127 | 0.8 | 0.8 | 0.8 | — |
| | Total | | 100.8 | 100.8 | 100.8 | — |
| Polysiloxane group | | | — | Present | Present | — |
| Thermally reactive group | Hydroxyl group | | Present | — | Present | — |
| | Epoxy group (glycidyl group) | | Present | — | Present | — |
| | Carboxy group | | — | — | — | — |
| | (Meth)acryloyl group | | — | — | — | — |
| Adhesive layer | | | Absent | Absent | Present | Absent |
| Accumulated light volume of radiation (ML/cm$^2$) | | | 500 | 500 | 500 | 500 |
| Evaluation | Tensile elongation (%) | | A | A | A | A |
| | Pencil hardness | | H | B | H | B |
| | Tight contact | | 100/100 | 0/100 | 100/100 | 100/100 |
| | Abrasion-resistance (ΔE) | | A | C | A | C |
| | Mold contamination (transfer) | | C | A | C | C |

The details of the abbreviations in Table 1 are as follows.

GMA: glycidyl methacrylate
AA: acryl acid
2-HEA: 2-hydroxyethyl acrylate
FM-0721: trade name, manufactured by JNC, 3-methacryloxy propyl dimethyl polysiloxane
MMA: methyl methacrylate
BA: butyl Acrylate
ABN-E: radical polymerization initiator, Azobis-2-methylbutyronitrile
MIBK: methyl isobutyl ketone
Karenz AOI: trade name, manufactured by Showa Denko K.K., isocyanatomethyl acrylate
IRGACURE 127: trade name, manufactured by BASF, polymerization initiator, 2-hydroxy-1-{4-[4-(2-hydroxy-2-methyl-propionyl)-benzyl] -phenyl } -2-methylpropane- 1 -one

While the illustrative embodiments of the present invention are provided in the above description, such is for illustrative purpose only and it is not to be construed restrictively. Modification and variation of the present invention that will be obvious to those skilled in the art is to be covered by the following claims.

Industrial Applicability

The hard coating layer-laminated mold resin and method of producing the hard coating layer-laminated mold resin of the present invention can be suitably used for various semiconductor industries.

Description of Reference Numerals

1    multi-layered sheet
2    substrate sheet
3    protective layer
5    transfer material

**Claims**

1.   A method of producing a hard coating layer-laminated mold resin comprising:

a transfer material preparation step of preparing a transfer material including a multi-layered sheet including a substrate sheet and a protective layer that is disposed on one surface of the substrate sheet and for protecting at least a part of a surface of a mold resin, the protective layer being an uppermost layer of the multi-layered sheet, the protective layer including a product of an active energy ray-curable resin cured or half-cured by active energy ray, and the protective layer having a thermally reactive group and a polysiloxane chain, and the thermally reactive group being capable of reacting and thermally curing with the mold resin in a thermally uncured and/or half-cured state;
a resin preparation step of preparing the thermally uncured and/or half-cured mold resin;
a disposition step of disposing the transfer material so that the protective layer is exposed; and
a transfer step of bringing into contact and heating the thermally uncured and/or half-cured mold resin and the protective layer to transfer a hard coating layer to the mold resin, the hard coating layer being produced by thermally curing the protective layer,
wherein,
in the transfer step, the protective layer and the mold resin are reacted and chemically bonded to each other, the thermally uncured and/or half-cured mold resin is cured, and the protective layer is further cured to form the hard coating layer.

2.   The method according to Claim 1, wherein, in the transfer step, the mold resin in a thermally uncured state and the protective layer in a thermally uncured state are heated in their contact situation to chemically bond the mold resin to the protective layer.

3.   The method according to Claim 1 or 2, wherein the transfer step comprising:

a first heating step of heating the mold resin in a thermally uncured state and the protective layer in a thermally uncured state in their contact situation to chemically bond the mold resin in a half-thermally cured state to the protective layer in a half-thermally cured state; and
a second heating step of heating the half-cured mold resin and the half-cured protective layer after the first heating step.

4.   The method according to Claim 1, wherein the transfer step comprises a transfer step of heating the mold resin molded in advance and in a half-thermally cured state and the protective layer in a thermally uncured state in their contact situation to chemically bond the mold resin to the protective layer.

5.   The method according to Claim 1 or 2, wherein in the transfer step comprises

a first heating step of heating the mold resin molded in advance and in a half-thermally cured state and the protective layer in a thermally uncured state in their contact situation to chemically bond the mold resin in a half-cured state and the protective layer in a half-cured state; and
a second heating step of heating the half-cured mold resin and the half-cured protective layer after the first heating step.

6.   The method according to any one of Claims 1 to 5, wherein

in the transfer step, a hard coating layer-laminated mold resin assembly including a plurality of the hard coating layer-laminated mold resins are molded, and
the method further comprises a dicing step of dividing the hard coating layer-laminated mold resin assembly into the plurality of hard coating layer-laminated mold resins after the transfer step.

7. The method according to Claim 6, wherein, in the dicing step, the plurality of hard coating layer-laminated mold resins are produced by blade dicing.

8. The method according to Claim 6, wherein, in the dicing step, the hard coating layer-laminated mold resins are produced by laser dicing.

9. The method according to any one of Claims 6 to 8, wherein a dicing tape is disposed before the division in the dicing step and after the transfer step.

10. The method according to any one of Claims 6 to 8, wherein a dicing tape is disposed before the division in the dicing step and before the transfer step.

11. The method according to any one of Claims 1 to 10, wherein a semiconductor device is sealed in the mold resin.

12. The method according to Claim 11, wherein the semiconductor device is a photo semiconductor device.

13. The method according to Claim 11 or 12, wherein the mold resin is epoxy resin and/or silicone resin.

14. The method according to Claim 13, wherein the thermally reactive group of the protective layer is at least one selected from a group consisting of a hydroxyl group, an epoxy group, a carboxy group, and a (meth)acryloyl group.

15. A hard coating layer-laminated mold resin comprising:

   a mold resin; and
   a hard coating layer that protects at least a part of a surface of the mold resin,
   wherein the hard coating layer is a cured product of an active energy ray-curable resin having a thermally reactive group and a polysiloxane chain, the thermally reactive group can react and thermally cure with the mold resin in a thermally uncured and/or half-cured state, and
   the hard coating layer and the mold resin are connected through a chemical bond of the thermally reactive group of the active energy ray-curable resin and the mold resin.

16. The hard coating layer-laminated mold resin according to Claim 15, further comprising a semiconductor device sealed in the mold resin.

17. The hard coating layer-laminated mold resin according to Claim 16, wherein the semiconductor device is a photosemiconductor device.

18. The hard coating layer-laminated mold resin according to Claim 17, wherein the photo semiconductor device is a light receiving element.

19. The hard coating layer-laminated mold resin according to Claim 17, wherein the photo semiconductor device is a light emitting element.

20. The hard coating layer-laminated mold resin according to any one of Claims 17 to 19 further comprising:

   a substrate electrically connected to the photosemiconductor device, wherein
   the substate, the mold resin and the hard coating layer are sequentially laminated from one side toward the other side,
   the mold resin includes a surface of the one side, a surface of the other side, and a peripheral surface connecting the surface of the one side and the surface of the other side, and
   the hard coating layer is disposed only on the surface of the other side of the mold resin and is not disposed on the peripheral surface of the mold resin.

21. The hard coating layer-laminated mold resin according to any one of Claims 17 to 20, wherein a surface roughness of the peripheral surface of the mold resin is larger than a surface roughness of the hard coating layer.

22. The hard coating layer-laminated mold resin according to any one of Claims 17 to 21, wherein a surface roughness of the peripheral surface of the hard coating layer is larger than the roughness of the surface of the hard coating layer.

**Patentansprüche**

1. Verfahren zur Herstellung eines mit einer harten Überzugsschicht laminierten Formharzes, umfassend:

    einen Übertragungsmaterialvorbereitungsschritt zur Vorbereitung eines Übertragungsmaterials, das eine mehrschichtige Folie umfasst, die eine Substratfolie und eine Schutzschicht umfasst, die auf einer Oberfläche der Substratschicht angeordnet ist, um mindestens einen Teil einer Oberfläche eines Formharzes zu schützen, wobei die Schutzschicht eine oberste Schicht der mehrschichtigen Folie ist, wobei die Schutzschicht ein Produkt eines mit aktiver Energiestrahlung härtbaren Harzes, das durch aktive Energiestrahlung gehärtet oder halb gehärtet wurde, umfasst, und die Schutzschicht eine thermisch reaktive Gruppe und eine Polysiloxankette aufweist, und die thermisch reaktive Gruppe in der Lage ist, mit dem Formharz in einem thermisch ungehärteten und/oder halb gehärteten Zustand zu reagieren und thermisch zu härten;
    einen Harzvorbereitungsschritt zur Vorbereitung des thermisch ungehärteten und/oder halb gehärteten Formharzes;
    einen Dispositionsschritt, bei dem das Transfermaterial so angeordnet wird, dass die Schutzschicht freigelegt wird; und
    einen Übertragungsschritt zum In-Kontakt-Bringen und Erhitzen des thermisch ungehärteten und/oder halb gehärteten Formharzes und der Schutzschicht, um eine harte Überzugsschicht auf das Formharz zu übertragen, wobei die harte Überzugsschicht durch thermisches Härten der Schutzschicht erzeugt wird,
    wobei,
    im Übertragungsschritt die Schutzschicht und das Formharz zur Reaktion gebracht und chemisch miteinander verbunden werden, das thermisch ungehärtete und/oder halb gehärtete Formharz gehärtet wird, und die Schutzschicht weiter gehärtet wird, um die harte Überzugsschicht zu bilden.

2. Verfahren nach Anspruch 1, wobei in dem Übertragungsschritt das Formharz in einem thermisch ungehärteten Zustand und die Schutzschicht in einem thermisch ungehärteten Zustand in ihrer Kontaktsituation erhitzt werden, um das Formharz mit der Schutzschicht chemisch zu verbinden.

3. Verfahren nach Anspruch 1 oder 2, wobei der Übertragungsschritt umfasst:

    einen ersten Erhitzungsschritt zum Erhitzen des Formharzes in einem thermisch ungehärteten Zustand und der Schutzschicht in einem thermisch ungehärteten Zustand in ihrer Kontaktsituation, um das Formharz in einem halb-thermisch gehärteten Zustand mit der Schutzschicht in einem halb-thermisch gehärteten Zustand chemisch zu verbinden; und
    einen zweiten Erhitzungsschritt zum Erhitzen des halb gehärteten Formharzes und der halb gehärteten Schutzschicht nach dem ersten Erhitzungsschritt.

4. Verfahren nach Anspruch 1, wobei der Übertragungsschritt einen Übertragungsschritt des Erhitzens des im Voraus geformten und in einem halb-thermisch gehärteten Zustand befindlichen Formharzes und der Schutzschicht in einem thermisch ungehärteten Zustand in ihrer Kontaktsituation umfasst, um das Formharz mit der Schutzschicht chemisch zu verbinden.

5. Verfahren nach Anspruch 1 oder 2, wobei der Übertragungsschritt Folgendes umfasst

    einen ersten Erhitzungsschritt zum Erhitzen des im Voraus geformten und in einem halb-thermisch gehärteten Zustand befindlichen Formharzes und der Schutzschicht in einem thermisch ungehärteten Zustand in ihrer Kontaktsituation, um das Formharz in einem halb gehärteten Zustand und die Schutzschicht in einem halb gehärteten Zustand chemisch zu verbinden; und
    einen zweiten Erhitzungsschritt zum Erhitzen des halb gehärteten Formharzes und der halb gehärteten Schutzschicht nach dem ersten Erhitzungsschritt.

6. Verfahren nach einem der Ansprüche 1 bis 5, wobei

in dem Übertragungsschritt eine harte Überzugsschicht-laminierte Formharzanordnung, die eine Vielzahl der harten Überzugsschicht-laminierten Formharze enthält, geformt wird, und

das Verfahren ferner einen Schritt des Schneidens der harten Überzugsschicht-laminierten Formharzanordnung in die Vielzahl von harten Überzugsschicht-laminierten Formharzen nach dem Übertragungsschritt umfasst.

7. Verfahren nach Anspruch 6, **dadurch gekennzeichnet, dass** im Schritt des Scheidens die Vielzahl der mit harten Überzugsschichten laminierten Formharze durch Schneiden mit einer Klinge hergestellt werden.

8. Verfahren nach Anspruch 6, **dadurch gekennzeichnet, dass** im Schritt des Schneidens die harten Überzugsschicht-laminierten Formharze durch Laserschneiden hergestellt werden.

9. Verfahren nach einem der Ansprüche 6 bis 8, wobei ein Schneidband vor der Teilung im Schritt des Schneidens und nach dem Übertragungsschritt angeordnet wird.

10. Verfahren nach einem der Ansprüche 6 bis 8, wobei ein Schneidband vor der Teilung im Schritt des Schneidens und vor dem Übertragungsschritt angeordnet wird.

11. Verfahren nach einem der Ansprüche 1 bis 10, wobei ein Halbleiterbauelement in dem Gießharz versiegelt wird.

12. Verfahren nach Anspruch 11, wobei das Halbleiterbauelement ein Photohalbleiterbauelement ist.

13. Verfahren nach Anspruch 11 oder 12, wobei das Formharz ein Epoxidharz und/oder ein Silikonharz ist.

14. Verfahren nach Anspruch 13, wobei die thermisch reaktive Gruppe der Schutzschicht mindestens eine ausgewählt aus einer Gruppe bestehend aus einer Hydroxylgruppe, einer Epoxygruppe, einer Carboxygruppe und einer (Meth)acryloylgruppe ist.

15. Harte Überzugsschicht-laminiertes Formharz, umfassend:

ein Formharz; und

eine harte Überzugsschicht, die mindestens einen Teil der Oberfläche des Formharzes schützt, wobei die harte Überzugsschicht ein gehärtetes Produkt eines mit aktiver Energiestrahlung härtbaren Harzes mit einer thermisch reaktiven Gruppe und einer Polysiloxankette ist, wobei die thermisch reaktive Gruppe mit dem Formharz in einem thermisch ungehärteten und/oder halb gehärteten Zustand reagieren und thermisch härten kann, und

die harte Überzugsschicht und das Formharz durch eine chemische Bindung der thermisch reaktiven Gruppe des mit aktiver Energiestrahlung härtbaren Harzes und des Formharzes verbunden sind.

16. Harte Überzugsschicht-laminiertes Formharz nach Anspruch 15, das ferner eine in das Formharz eingeschlossene Halbleitervorrichtung umfasst.

17. Harte Überzugsschicht-laminiertes Formharz nach Anspruch 16, wobei das Halbleiterbauelement ein Photohalbleiterbauelement ist.

18. Harte Überzugsschicht-laminiertes Formharz nach Anspruch 17, wobei das Photohalbleiterbauelement ein lichtempfangendes Element ist.

19. Harte Überzugsschicht-laminiertes Formharz nach Anspruch 17, wobei die Photohalbleiterbauelement ein lichtemittierendes Element ist.

20. Harte Überzugsschicht-laminiertes Formharz nach einem der Ansprüche 17 bis 19, ferner umfassend:

ein Substrat, das elektrisch mit der Photohalbleiterbauelement verbunden ist, wobei

das Substrat, das Formharz und die harte Überzugsschicht nacheinander von einer Seite zur anderen laminiert werden,

das Formharz eine Oberfläche der einen Seite, eine Oberfläche der anderen Seite und eine Umfangsfläche, die die Oberfläche der einen Seite und die Oberfläche der anderen Seite verbindet, aufweist, und

die harte Überzugsschicht nur auf der Oberfläche der anderen Seite des Formharzes und nicht auf der Umfangsfläche des Formharzes angeordnet ist.

21. Harte Überzugsschicht-laminiertes Formharz nach einem der Ansprüche 17 bis 20, wobei eine Oberflächenrauigkeit der Umfangsfläche des Formharzes größer ist als eine Oberflächenrauigkeit der harten Überzugsschicht.

22. Harte Überzugsschicht-laminiertes Formharz nach einem der Ansprüche 17 bis 21, wobei eine Oberflächenrauigkeit der Umfangsfläche der harten Überzugsschicht größer ist als eine Rauigkeit der Oberfläche der harten Überzugsschicht.

**Revendications**

1. Procédé de production d'une résine de moulage stratifiée avec une couche de revêtement dur comprenant :

une étape de préparation de matériau de transfert consistant à préparer un matériau de transfert comprenant une feuille multicouche comprenant une feuille de substrat et une couche protectrice qui est disposée sur une surface de la feuille de substrat et pour protéger au moins une partie d'une surface d'une résine de moulage, la couche protectrice étant une couche supérieure de la feuille multicouche, la couche protectrice comprenant un produit d'une résine durcissable par un rayonnement d'énergie active durcie ou semi-durcie par un rayonnement d'énergie active, et la couche protectrice ayant un groupe thermiquement réactif et une chaîne polysiloxane, et le groupe thermiquement réactif étant capable de réagir et de durcir thermiquement avec la résine de moulage dans un état thermiquement non durci et/ou semi-durci ;
une étape de préparation de résine consistant à préparer la résine de moulage thermiquement non durcie et/ou semi-durcie ;
une étape de disposition consistant à disposer le matériau de transfert de sorte que la couche protectrice soit exposée ; et
une étape de transfert consistant à mettre en contact et à chauffer la résine de moulage thermiquement non durcie et/ou semi-durcie et la couche protectrice pour transférer une couche de revêtement dur sur la résine de moulage, la couche de revêtement dur étant produite en durcissant thermiquement la couche protectrice, dans lequel,
dans l'étape de transfert, la couche protectrice et la résine de moulage sont mises à réagir et liées chimiquement l'une à l'autre, la résine de moulage thermiquement non durcie et/ou semi-durcie est durcie, et la couche protectrice est en outre durcie pour former la couche de revêtement dur.

2. Procédé selon la revendication 1, dans lequel, dans l'étape de transfert, la résine de moulage à l'état non durci thermiquement et la couche de protection à l'état non durci thermiquement sont chauffées dans leur situation de contact pour lier chimiquement la résine de moulage à la couche protectrice.

3. Procédé selon la revendication 1 ou 2, dans lequel l'étape de transfert comprenant :

une première étape de chauffage consistant à chauffer la résine de moulage dans un état non durci thermiquement et la couche protectrice dans un état non durci thermiquement dans leur situation de contact pour lier chimiquement la résine de moulage dans un état semi-durci thermiquement à la couche de protection dans un état semi-durci thermiquement ; et
une seconde étape de chauffage consistant à chauffer la résine de moulage semi-durcie et la couche protectrice semi-durcie après la première étape de chauffage.

4. Procédé selon la revendication 1, dans lequel l'étape de transfert comprend une étape de transfert consistant à chauffer la résine de moulage moulée à l'avance et dans un état semi-durci thermiquement et la couche de protection dans un état thermiquement non durci dans leur situation de contact pour lier chimiquement la résine de moulage à la couche protectrice.

5. Procédé selon la revendication 1 ou 2, dans lequel l'étape de transfert comprend

une première étape de chauffage consistant à chauffer la résine de moulage moulée à l'avance et dans un état semi-durci thermiquement et la couche de protection dans un état non durci thermiquement dans leur situation de contact pour lier chimiquement la résine de moulage dans un état semi-durci et la couche protectrice dans un état semi-durci ; et

une seconde étape de chauffage consistant à chauffer la résine de moulage semi-durcie et la couche protectrice semi-durcie après la première étape de chauffage.

6. Procédé selon l'une quelconque des revendications 1 à 5, dans lequel,

   dans l'étape de transfert, un assemblage de résine de moulage stratifiée avec une couche de revêtement dur comprenant une pluralité de résines de moulage stratifiées avec une couche de revêtement dur sont moulées, et le procédé comprend en outre une étape de découpage en dés consistant à diviser l'assemblage de résine de moulage stratifiée avec une couche de revêtement dur en la pluralité de résines de moulage stratifiées avec une couche de revêtement dur après l'étape de transfert.

7. Procédé selon la revendication 6, dans lequel, dans l'étape de découpage en dés, la pluralité de résines de moule stratifiées avec une couche de revêtement dur sont produites par découpage en dés à la lame.

8. Procédé selon la revendication 6, dans lequel, dans l'étape de découpage en dés, les résines de moulage stratifiées avec une couche de revêtement dur sont produites par découpage en dés au laser.

9. Procédé selon l'une quelconque des revendications 6 à 8, dans lequel une bande de découpage en dés est disposée avant la division dans l'étape de découpage en dés et après l'étape de transfert.

10. Procédé selon l'une quelconque des revendications 6 à 8, dans lequel une bande de découpage en dés est disposée avant la division dans l'étape de découpage en dés et avant l'étape de transfert.

11. Procédé selon l'une quelconque des revendications 1 à 10, dans lequel un dispositif semi-conducteur est scellé dans la résine de moulage.

12. Procédé selon la revendication 11, dans lequel le dispositif semi-conducteur est un dispositif photo-semi-conducteur.

13. Procédé selon la revendication 11 ou 12, dans lequel la résine de moulage est une résine époxy et/ou une résine silicone.

14. Procédé selon la revendication 13, dans lequel le groupe thermiquement réactif de la couche protectrice est au moins un groupe choisi dans un groupe constitué d'un groupe hydroxyle, d'un groupe époxy, d'un groupe carboxy et d'un groupe (méth)acryloyle.

15. Résine de moulage stratifiée avec une couche de revêtement dur comprenant :

    une résine de moulage ; et
    une couche de revêtement dur qui protège au moins une partie d'une surface de la résine de moulage,
    dans laquelle la couche de revêtement dur est un produit durci d'une résine durcissable par un rayonnement d'énergie active ayant un groupe thermiquement réactif et une chaîne polysiloxane,
    le groupe thermiquement réactif peut réagir et durcir thermiquement avec la résine de moulage dans un état thermiquement non durci et/ou semi-durci, et
    la couche de revêtement dur et la résine de moulage sont reliées par une liaison chimique du groupe thermiquement réactif de la résine durcissable par rayonnement d'énergie active et la résine de moulage.

16. Résine de moulage stratifiée avec une couche de revêtement dur selon la revendication 15, comprenant en outre un dispositif semi-conducteur scellé dans la résine de moulage.

17. Résine de moulage stratifiée avec une couche de revêtement dur selon la revendication 16, dans laquelle le dispositif semi-conducteur est un dispositif photo-semi-conducteur.

18. Résine de moulage stratifiée avec une couche de revêtement dur selon la revendication 17, dans laquelle le dispositif photo-semi-conducteur est un élément de réception de lumière.

19. Résine de moulage stratifiée avec une couche de revêtement dur selon la revendication 17, dans laquelle le dispositif photo-semi-conducteur est un élément émetteur de lumière.

**20.** Résine de moulage stratifiée avec une couche de revêtement dur selon l'une quelconque des revendications 17 à 19, comprenant en outre :

un substrat connecté électriquement au dispositif photo-semi-conducteur, dans laquelle le substrat, la résine de moulage et la couche de revêtement dur sont stratifiés séquentiellement d'un premier côté vers l'autre côté, la résine de moulage comprend une surface du premier côté, une surface de l'autre côté et une surface périphérique reliant la surface du premier côté et la surface de l'autre côté, et la couche de revêtement dur est disposée uniquement sur la surface de l'autre côté de la résine de moulage et n'est pas disposée sur la surface périphérique de la résine de moulage.

**21.** Résine de moulage stratifiée avec une couche de revêtement dur selon l'une quelconque des revendications 17 à 20, dans laquelle une rugosité de surface de la surface périphérique de la résine de moulage est supérieure à une rugosité de surface de la couche de revêtement dur.

**22.** Résine de moulage stratifiée avec une couche de revêtement dur selon l'une quelconque des revendications 17 à 21, dans laquelle une rugosité de surface de la surface périphérique de la couche de revêtement dur est supérieure à la rugosité de la surface de la couche de revêtement dur.

FIG. 1

1

FIG. 2

10

FIG. 3A

FIG. 3B

FIG. 3C

FIG. 3D

FIG. 4

1

FIG. 5A

FIG. 5B

FIG. 5C

FIG. 5D

FIG. 5E

FIG. 6A

FIG. 6B

FIG. 6C

FIG. 7D

FIG. 7E

FIG. 7F

FIG. 7G

FIG. 7H

FIG. 8

**EP 3 892 437 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2161126 A

- JP 2014193524 A